# EUROPEAN PATENT SPECIFICATION

(11) **EP 4 418 323 B1**
(45) Date of publication and mention of the grant of the patent: **03.12.2025**
(21) Application number: 24155756.0
(22) Date of filing: 05.02.2024
(51) Int. Cl.: H10F 39/00

(54) **IMAGE SENSOR HAVING NANO-PHOTONIC LENS ARRAY AND ELECTRONIC APPARATUS INCLUDING THE IMAGE SENSOR**
BILDSENSOR MIT NANOPHOTONISCHER LINSENANORDNUNG UND ELEKTRONISCHE VORRICHTUNG MIT DEM BILDSENSOR
CAPTEUR D'IMAGE AYANT UN RÉSEAU DE LENTILLES NANOPHOTONIQUES ET APPAREIL ÉLECTRONIQUE COMPRENANT LE CAPTEUR D'IMAGE

(30) Priority: 14.02.2023 KR 20230019538
(43) Date of publication of application: 21.08.2024
(73) Proprietor: Samsung Electronics Co., Ltd., Suwon-si, Gyeonggi-do 16677 (KR)
(72) Inventor: YUN, Seokho, 16678 Suwon-si (KR); ROH, Sookyoung, 16678 Suwon-si (KR); KIM, Daekwan, 18448 Hwaseong-si (KR); NOH, Yohwan, 18448 Hwaseong-si (KR); MOON, Jangho, 18448 Hwaseong-si (KR)
(74) Representative: Elkington and Fife LLP

(56) References cited:
- EP-A1- 4 258 641
- WO-A1-2022/121504
- US-A1- 2021 124 179
- US-A1- 2021 126 029

## Description

### FIELD OF THE INVENTION

One or more embodiments relate to an image sensor including a nano-photonic lens array and an electronic apparatus including the image sensor.

### BACKGROUND OF THE INVENTION

Image sensors generally sense the color of incident light by using a color filter. However, a color filter may have low light utilization efficiency because the color filter absorbs light of colors other than the intended color of light. For example, in the case in which a red-green-blue (RGB) color filter is used, only 1/3 of the incident light is transmitted therethrough and the other portion of the incident light, that is, 2/3 of the incident light, is absorbed. Thus, the light utilization efficiency of the RGB color filter is only about 33%. Thus, in a color display apparatus or a color image sensor, most light loss occurs in the color filter.

In addition, as pixel sizes in an image sensor are reduced, a binning technique for improving sensitivity under a low light level has been suggested. However, in an image sensor of a Bayer pattern type, the resolution of the image sensor may deteriorate when a binning mode is used. Accordingly, a new type of pixel arrangement other than the Bayer pattern has been suggested.

US Patent Application Number US 2021/126029 A1 describes a color separation element and an image sensor including the same.

International Patent Application Number WO 2022/121504 A1 describes an image processing method, an image processor, and an electronic device.

US Patent Application Number US 2021/124179 A1 describes a sensor substrate including two photosensitive cells and a color separating lens array including a first region and a second region.

### SUMMARY OF THE INVENTION

The invention is defined by the claims.

One or more example embodiments provide an image sensor including a nano-photonic lens array suitable for a new pixel arrangement.

Further, one or more example embodiments provide an electronic apparatus including an image sensor.

According to an embodiment, there is provided an image sensor according to claim 1.

The first pixel, the second pixel, the third pixel, and the fourth pixel may be alternately disposed in the first direction, and the first pixel, the second pixel, the third pixel, and the fourth pixel may be shifted by one pixel unit in the first direction in a following row in the second direction so that each of the first pixel, the second pixel, the third pixel, and the fourth pixel is disposed in a straight line in the first diagonal direction.

The first pixel corresponding region, the second pixel corresponding region, the third pixel corresponding region, and the fourth pixel corresponding region may be alternately disposed in the first direction, and the first pixel corresponding region, the second pixel corresponding region, the third pixel corresponding region, and the fourth pixel corresponding region may be shifted one-by-one in the first direction in a following row in the second direction so that each of the first pixel corresponding region, the second pixel corresponding region, the third pixel corresponding region, and the fourth pixel corresponding region is disposed in a straight line in the first diagonal direction.

In each of the first pixel corresponding region, the second pixel corresponding region, the third pixel corresponding region, and the fourth pixel corresponding region, the plurality of nano-structures may be two-dimensionally disposed, and in the first pixel corresponding region, the second pixel corresponding region, the third pixel corresponding region, and the fourth pixel corresponding region, locations, materials, and heights of the plurality of nano-structures may be equal to one another.

In the second pixel corresponding region, at least one pair from among pairs of two nano-structures corresponding to each other in the first direction may have different cross-sectional area sizes from each other, at least one pair from among pairs of two nano-structures corresponding to each other in the second direction may have different cross-sectional area sizes from each other, at least one pair from among pairs of two nano-structures corresponding to each other in the second diagonal direction may have different cross-sectional area sizes from each other, and pairs of two nano-structures corresponding to each other in the first diagonal direction may have same cross-sectional area sizes.

In the fourth pixel corresponding region, at least one pair from among pairs of two nano-structures corresponding to each other in the first direction may have different cross-sectional area sizes from each other, at least one pair from among pairs of two nano-structures corresponding to each other in the second direction may have different cross-sectional area sizes from each other, at least one pair from among pairs of two nano-structures corresponding to each other in the first diagonal direction may have different cross-sectional area sizes from each other, and pairs of two nano-structures corresponding to each other in the second diagonal direction may have same cross-sectional area sizes.

A distribution of cross-sectional area sizes of the plurality of nano-structures in the second pixel corresponding region and a distribution of cross-sectional area sizes of the plurality of nano-structures in the fourth pixel corresponding region may be mirror-symmetrical with each other in the first diagonal direction.

The cross-sectional area size of each of the plurality of nano-structures in the second pixel corresponding region may be equal to the cross-sectional area size of the nano-structure located at a symmetrical position in the first diagonal direction in the fourth pixel corresponding region.

The plurality of nano-structures may be disposed so that the light of the second wavelength that passed through a rectangular region obtained by connecting centers of two first pixel corresponding regions to centers of two third pixel corresponding regions that are adjacent to the second pixel corresponding region while contacting one sides thereof is condensed onto the second pixel, and the light of the second wavelength that passed through a rectangular region obtained by connecting centers of two first pixel corresponding regions to centers of two third pixel corresponding regions that are adjacent to the fourth pixel corresponding region while contacting one sides thereof is condensed onto the fourth pixel.

In the first pixel corresponding region and the third pixel corresponding region, the cross-sectional area sizes of the plurality of nano-structures may be distributed symmetrically in the first direction, the second direction, the first diagonal direction, and the second diagonal direction.

In each of the first pixel corresponding region and the third pixel corresponding region, two nano-structures corresponding to each other in the first direction may have the same cross-sectional area size, two nano-structures corresponding to each other in the second direction may have the same cross-sectional area size, two nano-structures corresponding to each other in the first diagonal direction may have the same cross-sectional area size, and two nano-structures corresponding to each other in the second diagonal direction may have the same cross-sectional area size.

The plurality of nano-structures may be disposed so that the light of the first wavelength that passed through a rectangular region obtained by connecting centers of two second pixel corresponding regions to centers of two fourth pixel corresponding regions that are adjacent to the first pixel corresponding region while contacting one sides thereof is condensed onto the first pixel, and the light of the third wavelength that passed through a rectangular region obtained by connecting centers of two second pixel corresponding regions to centers of two fourth pixel corresponding regions that are adjacent to the third pixel corresponding region while contacting one sides thereof is condensed onto the third pixel.

In the first pixel corresponding region and the third pixel corresponding region, the cross-sectional area sizes of the plurality of nano-structures may be distributed asymmetrically in the first direction and the second direction, and symmetrically in the first diagonal direction and the second diagonal direction.

In the first pixel corresponding region and the third pixel corresponding region, at least one pair from among pairs of two nano-structures corresponding to each other in the first direction may have different cross-sectional area sizes from each other, at least one pair from among pairs of two nano-structures corresponding to each other in the second direction may have different cross-sectional area sizes from each other, at least two nano-structures corresponding to each other in the first diagonal direction may have same cross-sectional area sizes, and two nano-structures corresponding to each other in the second diagonal direction may have same cross-sectional area sizes.

The plurality of nano-structures may be disposed so that the light of the first wavelength that passed through a rectangular region obtained by connecting apexes of two second pixel corresponding regions to apexes of two fourth pixel corresponding regions that are adjacent to the first pixel corresponding region while contacting one sides thereof is condensed onto the first pixel, and the light of the third wavelength that passed through a rectangular region obtained by connecting apexes of two second pixel corresponding regions to apexes of two fourth pixel corresponding regions that are adjacent to the third pixel corresponding region while contacting one sides thereof is condensed onto the third pixel.

Each of the first pixel, the second pixel, the third pixel, and the fourth pixel may include a plurality of photosensitive cells that are grouped in the first direction and the second direction to be two-dimensionally disposed and independently sense incident light.

The image sensor may further include a color filter layer disposed between the sensor substrate and the nano-photonic microlens array, wherein the color filter layer may include a first color filter corresponding to the first pixel and transmitting the light of the first wavelength, a second color filter corresponding to the second pixel and transmitting the light of the second wavelength, a third color filter corresponding to the third pixel and transmitting the light of the third wavelength, and a fourth color filter corresponding to the fourth pixel and transmitting the light of the second wavelength.

The first color filter, the second color filter, the third color filter, and the fourth color filter may be alternately disposed in the first direction, and the first color filter, the second color filter, the third color filter, and the fourth color filter may be shifted by one pixel unit in the first direction in a following row in the second direction so that each of the first color filter, the second color filter, the third color filter, and the fourth color filter is disposed in a line in the first diagonal direction.

According to another embodiment, an electronic apparatus includes a lens assembly for forming an optical image of a subject, an image sensor configured to convert the optical image formed by the lens assembly into an electrical signal, and a processor configured to process a signal generated by the image sensor, wherein the image sensor includes a sensor substrate including a first pixel, a second pixel, a third pixel, and a fourth pixel that are two-dimensionally disposed in a first direction and a second direction, and a nano-photonic lens array including a first pixel corresponding region corresponding to the first pixel, a second pixel corresponding region corresponding to the second pixel, a third pixel corresponding region corresponding to the third pixel, and a fourth pixel corresponding region corresponding to the fourth pixel, each of the first pixel corresponding region, the second pixel corresponding region, the third pixel corresponding region, and the fourth pixel corresponding region includes a plurality of nano-structures that are disposed to condense, in incident light, light of a first wavelength onto the first pixel, condense light of a second wavelength to the second pixel and the fourth pixel, and condense light of a third wavelength onto the third pixel, and in each of the second pixel corresponding region and the fourth pixel corresponding region, cross-sectional area sizes of the plurality of nano-structures are distributed symmetrically in the first direction, the second direction, and a first diagonal direction, and are distributed asymmetrically in a second diagonal direction that crosses the first diagonal direction.

According to another aspect of the disclosure, an image sensor may include: a plurality of pixels that comprises a first pixel, and four neighboring pixels that surround the first pixel; and a lens array comprising a plurality of pixel corresponding regions, wherein the plurality of pixel corresponding regions may include a first pixel corresponding region, and four neighboring pixel corresponding regions that surround the first pixel corresponding region, wherein the first pixel corresponding region and the four neighboring pixel corresponding regions are aligned correspondingly with the first pixel and the four neighboring pixels; wherein the lens array may include a plurality of nano-structures configured to condense light of a first wavelength onto the first pixel, when the light of the first wavelength is incident at any position within a first wavelength light condensing region of the lens array, and wherein the first wavelength light condensing region is an area formed by connecting centers of the four neighboring pixel corresponding regions.

Additional aspects will be set forth in part in the description which follows and, in part, will be apparent from the description, or may be learned by practice of the presented embodiments of the disclosure.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a block diagram of an image sensor according to an embodiment;
FIGS. 2A, 2B, and 2C are diagrams showing examples of various pixel arrangements in a pixel array of an image sensor;
FIG. 3 is a cross-sectional view schematically showing a structure of a pixel array in an image sensor according to an embodiment;
FIG. 4 is a plan view schematically showing a structure of a sensor substrate in the pixel array of FIG. 3;
FIG. 5 is a plan view schematically showing a structure of a color filter layer of FIG. 3;
FIG. 6 is a plan view showing an example of an arrangement of a plurality of nano-structures in the nano-photonic lens array of FIG. 3;
FIG. 7 is a diagram showing an example of passage of red light incident on a periphery of a first pixel corresponding region in a nano-photonic lens array;
FIG. 8 is a diagram showing an example of an array of a red light condensing region formed by a nano-photonic lens array;
FIG. 9 is a diagram showing an example of passage of green light incident on a periphery of a fourth pixel corresponding region in a nano-photonic lens array;
FIG. 10 is a diagram showing an example of an array of a green light condensing region formed by a nano-photonic lens array;
FIG. 11 is a diagram showing an example of passage of blue light incident on a periphery of a third pixel corresponding region in a nano-photonic lens array;
FIG. 12 is a diagram showing an example of an array of a blue light condensing region formed by a nano-photonic lens array;
FIG. 13 is a plan view showing an example of an arrangement of a plurality of nano-structures in a nano-photonic lens array according to another embodiment;
FIG. 14 is a diagram showing an example of a variable condition for selecting diameters of nano-structures according to positions thereof in the nano-photonic lens array of FIG. 13;
FIG. 15 is a graph showing light utilization efficiency of an image sensor including the nano-photonic lens array of FIG. 13 versus that of a comparative example;
FIG. 16 is a plan view showing an example of an arrangement of a plurality of nano-structures in a nano-photonic lens array according to another embodiment;
FIGS. 17 to 19 are diagrams showing examples of arrangement types of a red light condensing region, a green light condensing region, and a blue light condensing region in the nano-photonic lens array of FIG. 16;
FIG. 20 is a block diagram of an electronic device including an image sensor according to an embodiment; and
FIG. 21 is a block diagram schematically showing a camera module of FIG. 20.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. Expressions such as "at least one of," when preceding a list of elements, modify the entire list of elements and do not modify the individual elements of the list.

Hereinafter, an image sensor including a nano-photonic lens array and an electronic apparatus including the image sensor will be described in detail with reference to accompanying drawings. The embodiments of the disclosure are capable of various modifications and may be embodied in many different forms. In the drawings, like reference numerals denote like components, and sizes of components in the drawings may be exaggerated for convenience of explanation.

When a layer, a film, a region, or a panel is referred to as being "on" another element, it may be directly on/under/at left/right sides of the other layer or substrate, or intervening layers may also be present.

It will be understood that although the terms "first," "second," etc. may be used herein to describe various components, these components should not be limited by these terms. These terms are only used to distinguish one component from another. These terms do not limit that materials or structures of components are different from one another.

An expression used in the singular encompasses the expression of the plural, unless it has a clearly different meaning in the context. It will be further understood that when a portion is referred to as "comprising" another component, the portion may not exclude another component but may further comprise another component unless the context states otherwise.

In addition, the terms such as "... unit", "module", etc. provided herein indicates a unit performing a function or operation, and may be realized by hardware, software, or a combination of hardware and software.

The use of the terms of "the above-described" and similar indicative terms may correspond to both the singular forms and the plural forms.

Also, the steps of all methods described herein may be performed in any suitable order unless otherwise indicated herein or otherwise clearly contradicted by context. Also, the use of all exemplary terms (for example, etc.) is only to describe a technical detail, and the scope of rights is not limited by these terms unless the context is limited by the claims.

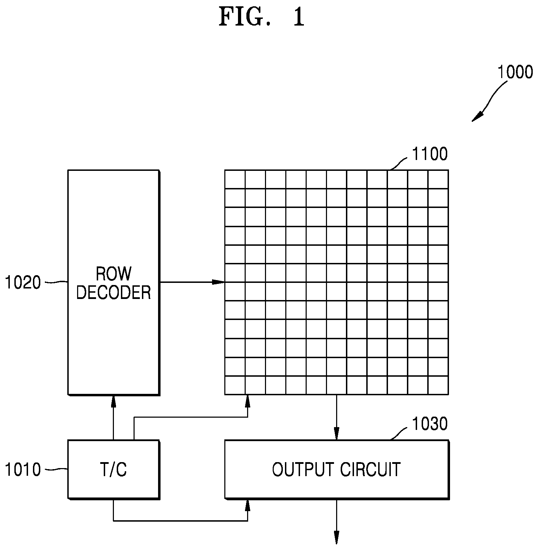

FIG. 1 is a schematic block diagram of an image sensor 1000 according to an embodiment. Referring to FIG. 1, the image sensor 1000 may include a pixel array 1100, a timing controller (T/C) (e.g., a timing control circuit) 1010, a row decoder 1020, and an output circuit 1030. The image sensor 1000 may include a charge-coupled device (CCD) image sensor or a complementary metal oxide semiconductor (CMOS) image sensor.

The pixel array 1100 includes pixels that are two-dimensionally disposed in a plurality of rows and columns. The row decoder 1020 selects one of the rows in the pixel array 1100 in response to a row address signal output from the timing controller 1010. The output circuit 1030 outputs a photosensitive signal, in a line unit, from a plurality of pixels disposed in the selected row. To this end, the output circuit 1030 may include a column decoder and an analog-to-digital converter (ADC). For example, the output circuit 1030 may include a plurality of ADCs that are disposed respectively to columns between the column decoder and the pixel array 1100, or one ADC disposed at an output end of the column decoder. The timing controller 1010, the row decoder 1020, and the output circuit 1030 may be implemented as one chip or in separate chips. A processor for processing an image signal output from the output circuit 1030 may be implemented as one chip with the timing controller 1010, the row decoder 1020, and the output circuit 1030.

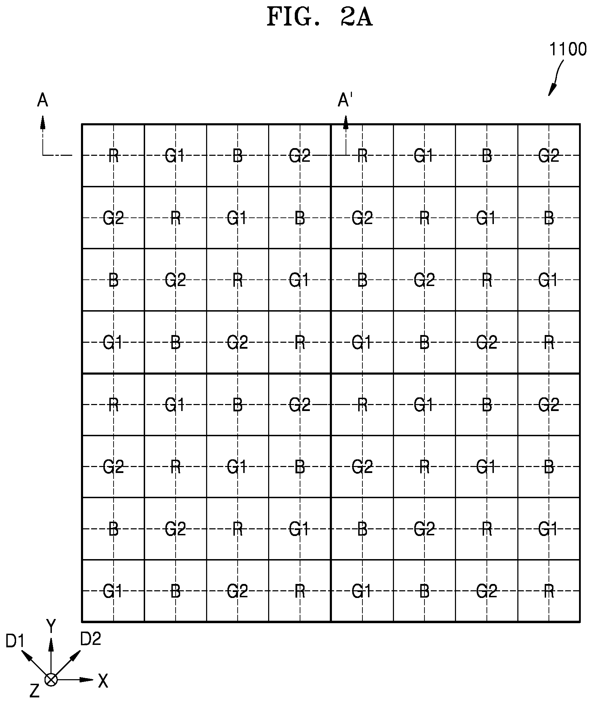

The pixel array 1100 may include a plurality of pixels that sense light of different wavelengths. The pixel arrangement may be implemented in various ways. For example, FIGS. 2A to 2C show various pixel arrangements in the pixel array 1100 of the image sensor 1000.

Referring to FIG. 2A, one first green pixel G1 and one second green pixel G2 may be alternately positioned every two pixels in a first direction (that is, X-axis direction). In addition, a blue pixel B and a red pixel R may be alternately disposed between the first green pixel G1 and the second green pixel G2 that are adjacent to each other. For example, the blue pixel B may be disposed between the first green pixel G1 and the second green pixel G2, and the red pixel R may be disposed between the second green pixel G2 and the first green pixel G1. Likewise, in a second direction (that is, Y-axis direction), one first green pixel G1 and one second green pixel G2 may be alternately positioned every two pixels, and the blue pixel B and the red pixel R may be alternately disposed between the first green pixel G1 and the second green pixel G2 that are adjacent to each other. Therefore, in both the first and second directions, a red pixel R and a blue pixel B may be regularly disposed every four pixels. In this case, a plurality of unit patterns each having a 4x4 array may be repeatedly disposed in the first direction and the second direction.

In FIG. 2A, each unit pattern shows a pixel arrangement where the pixels are organized in a specific order in the first and second directions. For example, in each unit pattern, the pixels are disposed in an order of the red pixel R, the first green pixel G1, the blue pixel B, and the second green pixel G2 in the first direction, and the pixels are disposed in an order of the red pixel R, the second green pixel G2, the blue pixel B, and the first green pixel G1 in the second direction as an example. However, one or more embodiments are not limited thereto. The pixels may be disposed according to the above-mentioned rule regardless of which pixel is disposed first. In the entire pixel array 1100, the number of the red pixels R and the number of the blue pixels B are equal to each other, and sum of the number of the first green pixels G1 and the number of the second green pixels G2 is twice as many as the number of the red pixels R and the number of the blue pixels B or is equal to sum of the number of the red pixels R and the number of blue pixels B.

Also, in the pixel arrangement shown in FIG. 2A, each of the red pixels R, the first green pixels G1, the blue pixels B, and the second green pixels G2 is disposed in a row along one diagonal direction. For example, a plurality of red pixels R may be disposed in a line in a first diagonal direction D1 (or -45° direction) while contacting apexes of one another, a plurality of first green pixels G1 may be disposed in a line in the first diagonal direction D1 while contacting apexes of one another, a plurality of blue pixels B may be disposed in a line in the first diagonal direction D1 while contacting apexes of one another, and a plurality of second green pixels G2 may be disposed in a line in the first diagonal direction D1 while contacting apexes of one another. Also, in a second diagonal direction D2 (or +45° direction) crossing the first diagonal direction D1, the plurality of first green pixels G1 and the plurality of second green pixels G2 may be alternately disposed, and the plurality of red pixels R and the plurality of blue pixels B may be alternately disposed.

Also, around the red pixel R in the first and second directions, the first green pixels G1 and the second green pixels G2 may be disposed contacting four sides of the red pixel R. For example, the first green pixels G1 may be disposed contacting the right and upper sides of the red pixel R, and the second green pixels G2 may be disposed contacting the left and lower sides of the red pixel R. In addition, around the blue pixel B in the first and second directions, the first and second green pixels G1 and G2 may be disposed contacting four sides of the blue pixel B. For example, the second green pixels G2 may be disposed contacting the right and upper sides of the blue pixel B, and the first green pixels G1 may be disposed contacting the left and lower sides of the blue pixel B. Therefore, the green pixels may be in contact with all four sides of the red pixel R and the blue pixel B. In this point of view, the pixel arrangements around the red pixel R and the blue pixel B may be symmetrical in the first direction and the second direction.

In the case of the first green pixel G1, the blue pixels B may be disposed contacting the right and upper sides of the first green pixel G1 and the red pixels R may be disposed contacting the left and lower sides of the first green pixel G1. Therefore, pixels of different colors, e.g., the red pixel R and the blue pixel B, are disposed at left and right sides of the first green pixel G1, and pixels of different colors are disposed at lower and upper sides of the first green pixel G1. Also, the red pixels R may be disposed contacting the right and upper sides of the second green pixel G2, and the blue pixels B may be disposed contacting the left and lower sides of the second green pixel G2. Therefore, pixels of different colors are disposed at the left and right sides of the second green pixel G2, and pixels of different colors are disposed at the lower and upper sides of the second green pixel G2. In this point, the pixel arrangement around the first green pixel G1 and the pixel arrangement around the second green pixel G2 are asymmetrical in the first direction and in the second direction, and are also asymmetrical in the first diagonal direction D1 and symmetrical in the second diagonal direction D2. Also, in the pixel arrangement around the first green pixel G1 and the pixel arrangement around the second green pixel G2, the red pixels R and the blue pixels B are exchanged with each other.

In addition, as indicated by dashed lines in FIG. 2A, each of the red pixel R, the first green pixel G1, the blue pixel B, and the second green pixel G2 may be divided into a plurality of independent photosensitive cells. The independent photosensitive cells may sense light individually and independently, and may convert the light into separate electrical signals based on the amount of light they receive. FIG. 2A shows an example in which each of the red pixel R, the first green pixel G1, the blue pixel B, and the second green pixel G2 is divided into four independent photosensitive cells. When each of the pixels of the same color is divided into a plurality of independent photosensitive cells to sense the light, a binning mode operation for increasing sensitivity in a low-illuminance environment may be performed. The binning mode is an image processing method in which outputs from a plurality of independent photosensitive cells are summed or outputs from a plurality of pixels of the same color are summed.

The pixel arrangement shown in FIG. 2A may be considered as a deformation from the pixel arrangement in a Bayer pattern. In the pixel arrangement shown in FIG. 2A, a demosaic process may be omitted when using the binning mode, unlike the pixel arrangement in the Bayer pattern type. Therefore, even when the binning mode is used in order to increase the sensitivity under the low-illuminance environment, the resolution may not degrade. Also, an additional calculation for the demosaic is not necessary, and thus, the power consumption of the image sensor 1000 may be reduced.

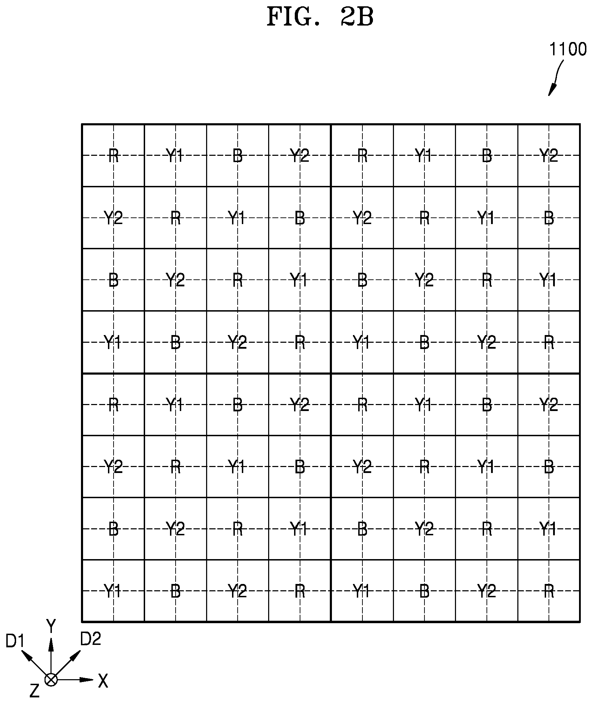

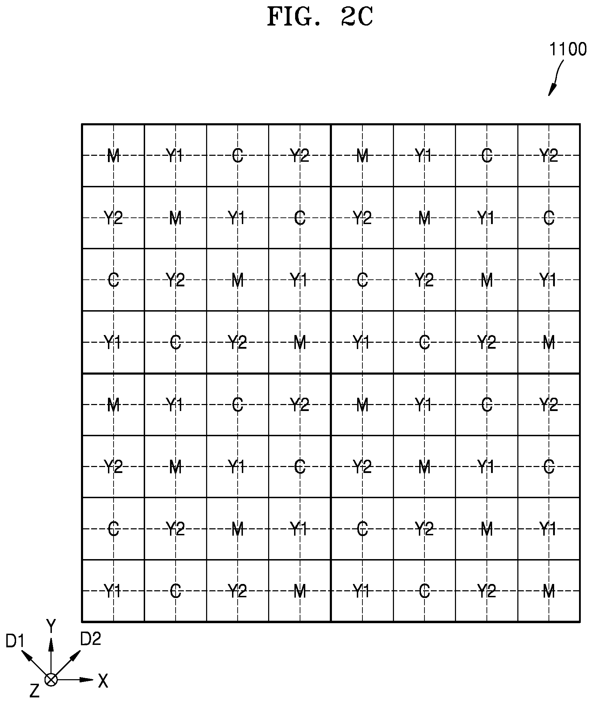

The arrangement method of the pixel array 1100 may be various, other than the method shown in FIG. 2A. For example, referring to FIG. 2B, the pixels may be disposed in a red-yellow-blue (RYB) type including red pixels, blue pixels, and yellow pixels. In this case, instead of the first green pixel G1 and the second green pixel G2 of FIG. 2A, a first yellow pixel Y1 and a second yellow pixel Y2 may be used. Also, referring to FIG. 2C, a cyan-magenta-yellow (CMY) type including cyan pixels, magenta pixels, and yellow pixels may be used to arrange pixels. In this case, instead of the blue pixel B and the red pixel R of FIG. 2B, a cyan pixel C and a magenta pixel M may be used. In addition to the above examples, the pixels in the pixel array 1100 may be disposed in various ways according to color characteristics of the image sensor 1000. In the description below, the pixel array 1100 of the image sensor 1000 has the RGB arrangement shown in FIG. 2A, but operating principles may be applied to the other types of pixel arrangement.

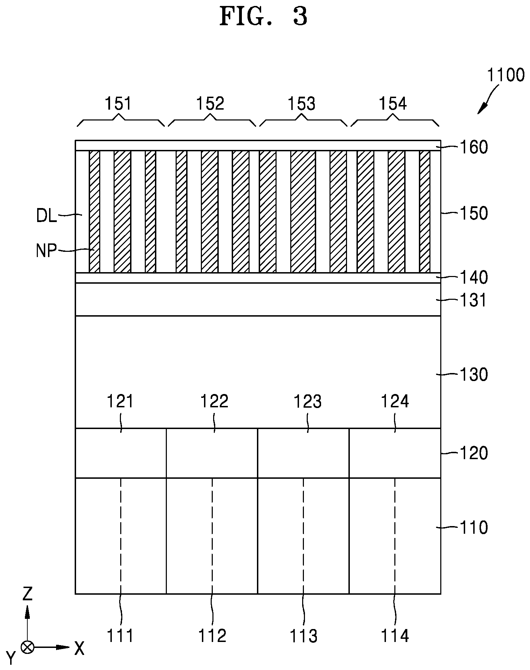

FIG. 3 is a cross-sectional view schematically showing the pixel array 1100 of the image sensor 1000 according to an embodiment. In particular, FIG. 3 shows an example of a cross-section of the pixel array 1100 taken along with line A-A' of FIG. 2A.

Referring to FIG. 3, the pixel array 1100 may include a sensor substrate 110 and a nano-photonic lens array 150 disposed facing the sensor substrate 110. Also, the pixel array 1100 may further include a color filter layer 120 disposed between the sensor substrate 110 and the nano-photonic lens array 150, and a planarization layer 130 disposed between the color filter layer 120 and the nano-photonic lens array 150. For example, the color filter layer 120 may be disposed on the sensor substrate 110, the planarization layer 130 may be disposed on the color filter layer 120, and the nano-photonic lens array 150 may be disposed on the planarization layer 130. Also, the pixel array 1100 may further include an encapsulation layer 131 disposed between the planarization layer 130 and the nano-photonic lens array 150. Also, the pixel array 1100 may further include an etch stop layer 140 between the encapsulation layer 131 and the nano-photonic lens array 150. Also, the pixel array 1100 may further include an anti-reflection layer 160 disposed on a light incident surface of the nano-photonic lens array 150. The encapsulation layer 131, the etch stop layer 140, and the anti-reflection layer 160 may be omitted.

The sensor substrate 110 may include a plurality of pixels sensing incident light. For example, the sensor substrate 110 may include a plurality of first pixels 111, a plurality of second pixels112, a plurality of third pixels 113, and a plurality of fourth pixels 114 that convert incident light into electrical signals and generate an image signal. The first, second, third, and fourth pixels 111, 112, 113, and 114 may respectively correspond to the red pixels R, the first green pixels G1, the blue pixels B, and the second green pixels G2 shown in FIG. 2A. For example, the first pixel 111 may be a red pixel sensing red light, the second pixel 112 and the fourth pixel 114 may be green pixels sensing green light, and the third pixel 113 may be a blue pixel sensing blue light.

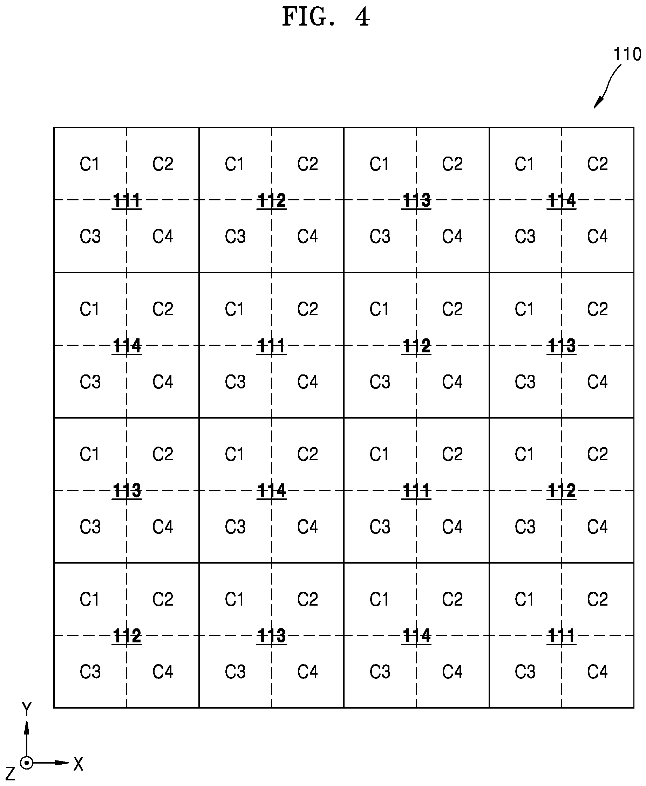

FIG. 4 is a plan view schematically showing a structure of a sensor substrate 110 in the pixel array 1100 of FIG. 3. FIG. 4 shows an example of one unit pattern having 4x4 array, but the pixel array 1100 may include a plurality of unit patterns that are two-dimensionally disposed in the first direction and the second direction. Referring to FIG. 4, the first pixel 111, the second pixel 112, the third pixel 113, and the fourth pixel 114 are alternately disposed in the first direction in a first row, the fourth pixel 114, the first pixel 111, the second pixel 112, and the third pixel 113 are alternately disposed in the first direction in a second row, the third pixel 113, the fourth pixel 114, the first pixel 111, and the second pixel 112 are alternately disposed in the first direction in a third row, and the second pixel 112, the third pixel 113, the fourth pixel 114, and the first pixel 111 are alternately disposed in the first direction in a fourth row.

Therefore, in a row following any one row in the second direction, the pixels may be shifted by one pixel unit in the first direction with respect to the previous row. For example, the first pixel 111, the second pixel 112, the third pixel 113, and the fourth pixel 114 disposed in the second row may be shifted by one pixel unit in the first direction with respect to the first pixel 111, the second pixel 112, the third pixel 113, and the fourth pixel 114 disposed in the first row. Then, the same color pixels may be disposed in a line along one diagonal direction. For example, a plurality of first pixels 111 are disposed in a straight line in a diagonal direction while contacting the apexes of one another, a plurality of second pixels 112 are disposed in a line in the diagonal direction while contacting the apexes of one another, a plurality of third pixels 113 are disposed in a line in the diagonal direction while contacting the apexes of one another, and a plurality of fourth pixels 114 are disposed in a line in the diagonal direction while contacting the apexes of one another. In the above-mentioned manner, the first to fourth pixels 111, 112, 113, and 114 may be two-dimensionally disposed in the first and second directions.

Also, each of the first to fourth pixels 111, 112, 113, and 114 may include a plurality of photosensitive cells that independently sense incident light. For example, each of the first to fourth pixels 111, 112, 113, and 114 may include first to fourth photosensitive cells C1, C2, C3, and C4. The first to fourth photosensitive cells C1, C2, C3, and C4 may be two-dimensionally disposed in the first direction and the second direction. For example, in each of the first to fourth pixels 111, 112, 113, and 114, the first to fourth photosensitive cells C1, C2, C3, and C4 may be disposed in a 2x2 array. Each of the first to fourth photosensitive cells C1, C2, C3, and C4 may include a photodiode sensing light, and a switching circuit controlling operations of the photodiode. Therefore, when each of the first to fourth pixels 111, 112, 113, and 114 includes the first to fourth photosensitive cells C1, C2, C3, and C4 disposed in 2x2 array, each of the first to fourth pixels 111, 112, 113, and 114 may include four photodiodes operating independently from one another.

FIG. 4 shows an example in which each of the first to fourth pixels 111, 112, 113, and 114 includes four photosensitive cells, but four or more independent photosensitive cells may be grouped and two-dimensionally disposed. For example, each of the first to fourth pixels 111, 112, 113, and 114 may include a plurality of independent photosensitive cells that are grouped and two-dimensionally disposed in a 3x3 array or 4x4 array. Hereinafter, an example in which each of the first to fourth pixels 111, 112, 113, and 114 includes the photosensitive cells two-dimensionally disposed in a 2x2 array will be described for convenience of description.

According to the embodiment, an auto-focusing signal may be obtained by comparing output signals of adjacent photosensitive cells based on differences between the output signals. For example, in the first direction, an auto-focusing signal may be generated by calculating a difference between output signals from the first photosensitive cell C1 and the second photosensitive cell C2, a difference between output signals from the third photosensitive cell C3 and the fourth photosensitive cell C4, or a difference between a sum of the output signals from the first photosensitive cell C1 and the third photosensitive cell C3 and a sum of the output signals from the second photosensitive cell C2 and the fourth photosensitive cell C4. Also, in the second direction, an auto-focusing signal may be generated by calculating a difference between output signals from the first photosensitive cell C1 and the third photosensitive cell C3, a difference between output signals from the second photosensitive cell C2 and the fourth photosensitive cell C4, or a difference between a sum of the output signals from the first photosensitive cell C1 and the second photosensitive cell C2 and a sum of the output signals from the third photosensitive cell C3 and the fourth photosensitive cell C4.

An RGB image signal may be obtained in various ways. For example, in the case of a full-sized image, output signals from the first to fourth photosensitive cells C1, C2, C3, and C4 may be used as independent image signals. In this case, the first pixel 111 may generate four red image signals, each of the second pixel 112 and the fourth pixel 114 may generate four green image signals, and the third pixel 113 may generate four blue image signals.

In a first binning mode, the output signals from the first to fourth photosensitive cells C1, C2, C3, and C4 may be summed to obtain an image signal. For example, a red image signal may be generated by summing the output signals from the first to fourth photosensitive cells C1, C2, C3, and C4 of the first pixel 111, a first green image signal may be generated by summing the output signals from the first to fourth photosensitive cells C1, C2, C3, and C4 of the second pixel 112, a blue image signal may be generated by summing the output signals from the first to fourth photosensitive cells C1, C2, C3, and C4 of the third pixel 113, and a second green image signal may be generated by summing the output signals from the first to fourth photosensitive cells C1, C2, C3, and C4 of the fourth pixel 114. In this case, each of the first to fourth pixels 111, 112, 113, and 114 may generate one image signal.

Also, in a second binning mode, outputs from two same pixels that are adjacent to each other in the diagonal direction may be summed to generate an image signal. For example, one red image signal may be generated by summing output signals from the first to fourth photosensitive cells C1, C2, C3, and C4 of two first pixels 111 adjacent to each other in the diagonal direction, one first green image signal may be generated by summing output signals from the first to fourth photosensitive cells C1, C2, C3, and C4 of two second pixels 112 adjacent to each other in the diagonal direction, one blue image signal may be generated by summing output signals from the first to fourth photosensitive cells C1, C2, C3, and C4 of two third pixels 113 adjacent to each other in the diagonal direction, and one second green image signal may be generated by summing output signals from the first to fourth photosensitive cells C1, C2, C3, and C4 of two fourth pixels 114 adjacent to each other in the diagonal direction.

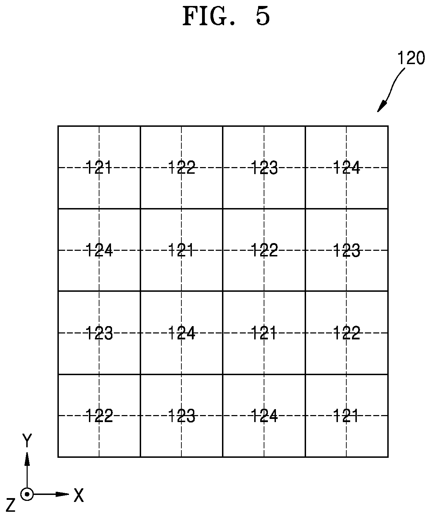

FIG. 5 is a plan view schematically showing a structure of the color filter layer 120 of FIG. 3. Referring to FIG. 5, the color filter layer 120 may include a plurality of color filters each transmitting light of a certain wavelength and absorbing light of another wavelength. For example, the color filter layer 120 may include a plurality of first color filters 121 transmitting light of a first wavelength and absorbing light of another wavelength, a plurality of second color filters 122 transmitting light of a second wavelength that is different from the first wavelength and absorbing light of another wavelength, a plurality of third color filters 123 transmitting light of a third wavelength that is different from the first and second wavelengths and absorbing light of another wavelength, and a plurality of fourth color filters 124 transmitting light of the second wavelength and absorbing light of another wavelength.

The first color filter 121 may be disposed to face the first pixel 111 in a third direction (that is, Z-axis direction), the second color filter 122 may be disposed to face the second pixel 112 in the third direction, the third color filter 123 may be disposed to face the third pixel 113 in the third direction, and the fourth color filter 124 may be disposed to face the fourth pixel 114 in the third direction. Therefore, the first to fourth color filters 121, 122, 123, and 124 may be two-dimensionally disposed in the same manner as that of the first to fourth pixels 111, 112, 113, and 114 described above with reference to FIG. 4. For example, the first to fourth color filters 121, 122, 123, and 124 may be alternately disposed in the first direction. In addition, the first to fourth color filters 121, 122, 123, and 124 are shifted one-by-one in the first direction in a following row in the second direction, and then, each of the first to fourth color filters 121, 122, 123, and 124 may be disposed in a line in the first diagonal direction D1.

Accordingly, the first pixel 111 may sense the light of the first wavelength that has passed through the first color filter 121 corresponding thereto. The second pixel 112 and the fourth pixel 114 may sense the light of the second wavelength that has passed through the second color filter 122 and the fourth color filter 124 corresponding thereto. The third pixel 113 may sense the light of the third wavelength that has passed through the third color filter 123 corresponding thereto. For example, the light of the first wavelength may be red light, the light of the second wavelength may be green light, and the light of the third wavelength may be blue light. Therefore, the first color filter 121 may be a red color filter transmitting the red light, the second color filter 122 and the fourth color filter 124 may be green color filters transmitting the green light, and the third color filter 123 may be a blue color filter transmitting the blue light.

Dashed lines shown in FIG. 5 indicate the boundaries separating the photosensitive cells in the first to fourth pixels 111, 112, 113, and 114. As shown in FIG. 5, the first to fourth color filters 121, 122, 123, and 124 may be disposed to face all the photosensitive cells in the first to fourth pixels 111, 112, 113, and 114 respectively corresponding thereto in the third direction. In other words, the first color filter 121 covers (or aligns with) all photosensitive cells in the first pixel 111, the second color filter 122 covers (or aligns with) all photosensitive cells in the second pixel 112, the third color filter 123 covers (or aligns with) all photosensitive cells in the third pixel 113, and the fourth color filter 124 covers (or aligns with) all photosensitive cells in the fourth pixel 114.

The first to fourth color filters 121, 122, 123, and 124 in the color filter layer 120 may be formed of, for example, an organic polymer material. For example, the first to fourth color filters 121, 122, 123, and 124 may include a coloring agent, binder resin, polymer photoresist, etc. The first color filter 121 may be an organic color filter including red organic dye or a red organic pigment as a coloring agent, the second and fourth color filters 122 and 124 may be organic color filters including a green organic dye or a green organic pigment as a coloring agent, and the third color filter 123 may be an organic color filter including a blue organic dye or a blue organic pigment as a coloring agent. The color filter layer 120 may further include a black matrix disposed at boundaries between the first to fourth color filters 121, 122, 123, and 124. The black matrix may include, for example, carbon black.

In FIG. 3, although the color filter layer 120 is shown to have a flat upper surface for convenience's sake, the upper surface of each of the first to fourth color filters 121, 122, 123, and 124 may not be flat, and may be curved. Also, thicknesses of the first to fourth color filters 121, 122, 123, and 124 and the black matrix may not be identical to each other. The planarization layer 130 on the color filter layer 120 may provide a flat surface for forming the nano-photonic lens array 150 thereon. The planarization layer 130 may include an organic polymer material that is suitable for being stacked on the color filter layer 120 that is formed of an organic material and may easily form a flat surface. The organic polymer material forming the planarization layer 130 may be transparent with respect to visible light. For example, the planarization layer 130 may include at least one organic polymer material from an epoxy resin, polyimide, polycarbonate, polyacrylate, and polymethyl methacrylate (PMMA). The planarization layer 130 may be formed on the color filter layer 120 by, for example, a spin coating method, and may have a flat upper surface through a thermal treatment.

An encapsulation layer 131 may be further disposed on the planarization layer 130. The encapsulation layer 131 may serve multiple functions in the pixel array 1100. For example, the encapsulation layer 131 may act as a protective layer for preventing the planarization layer 130 formed of an organic polymer material from potential damages during a process of forming the nano-photonic lens array 150 on the planarization layer 130. Also, the encapsulation layer 131 may serve as a diffusion barrier layer that prevents a metal component in the color filter layer 120 from passing through the planarization layer 130 and being exposed to outside due to the high temperature during the process of forming the nano-photonic lens array 150. To this end, the encapsulation layer 131 may include an inorganic material. The inorganic material of the encapsulation layer 131 may be formed at a temperature lower than a processing temperature for forming the nano-photonic lens array 150 and may include a material transparent with respect to visible light. Also, a refractive index of the encapsulation layer 131 may be similar to that of the planarization layer 130 in order to reduce reflection loss at an interface between the planarization layer 130 and the encapsulation layer 131. For example, a difference between the refractive index of the planarization layer 130 and the refractive index of the encapsulation layer 131 may be within ±20% of the refractive index of the planarization layer 130. For example, the encapsulation layer 131 may include at least one inorganic material selected from SiO₂, SiN, and SiON.

Also, the nano-photonic lens array 150 may include a plurality of first pixel corresponding regions 151 corresponding to the plurality of first pixels 111, a plurality of second pixel corresponding regions 152 corresponding to the plurality of second pixels 112, a plurality of third pixel corresponding regions 153 corresponding to the plurality of third pixels 113, and a plurality of fourth pixel corresponding regions 154 corresponding to the plurality of fourth pixels 114. The first pixel corresponding regions 151 may be disposed so as to face the first pixels 111 and the first color filters 121 in the third direction, the second pixel corresponding regions 152 may be disposed so as to face the second pixels 112 and the second color filters 122 in the third direction, the third pixel corresponding regions 153 may be disposed so as to face the third pixels 113 and the third color filters 123 in the third direction, and the fourth pixel corresponding regions 154 may be disposed so as to face the fourth pixels 114 and the fourth color filters 124 in the third direction. Therefore, the first to fourth pixel corresponding regions 151, 152, 153, and 154 may be two-dimensionally disposed in the same manner as that of the first to fourth pixels 111, 112, 113, and 114 described above with reference to FIG. 4. For example, the first pixel corresponding region 151, the second pixel corresponding region 152, the third pixel corresponding region 153, and the fourth pixel corresponding region 154 may be alternately disposed in the first direction. In addition, in a following row in the second direction, the first pixel corresponding region 151, the second pixel corresponding region 152, the third pixel corresponding region 153, and the fourth pixel corresponding region 154 are shifted one-by-one in the first direction, and thus, each of the first to fourth pixel corresponding regions 151, 152, 153, and 154 may be disposed in a line in the first diagonal direction D1.

According to the embodiment, the nano-photonic lens array 150 may color-separate the incident light according to wavelengths thereof and condense the separated light of each wavelength onto a pixel corresponding to the wavelength. In other words, the nano-photonic lens array 150 may condense light of the first wavelength, in the incident light, onto the first pixel 111, condense light of the second wavelength onto the second pixel 112 and the fourth pixel 114, and condense light of the third wavelength onto the third pixel 113. Then, the incident light is separated by the nano-photonic lens array 150 according to wavelengths and then condensed to the first to fourth pixels 111, 112, 113, and 114. For example, the nano-photonic lens array 150 separates the incident light into red light, green light, and blue light, and condenses the red light onto the first pixel 111, the green light onto the second and fourth pixels 112 and 114, and the blue light onto the third pixel 113. Because the incident light is color-separated by the nano-photonic lens array 150 to a considerable degree, the absorption loss may be low even when the color filter layer 120 is used. Also, color purity may be improved because the nano-photonic lens array 150 and the color filter layer 120 are used together. The color filter layer 120 may be omitted provided that the sufficient color separate may be generated by the nano-photonic lens array 150.

Each of the first to fourth pixel corresponding regions 151, 152, 153, and 154 of the nano-photonic lens array 150 may include a plurality of nano-structures NP that are disposed to color-separate the incident light according to the wavelengths and condense the separated light of each wavelength respectively onto the first to fourth pixels 111, 112, 113, and 114. The plurality of nano-structures NP may be disposed so that a phase of light transmitting through the nano-photonic lens array 150 is changed according to a position on the nano-photonic lens array 150. Each of the plurality of nano-structures NP may have a pillar shape extending in the third direction. Also, each of the plurality of nano-structures NP may have a certain cross-sectional shape such as a circular shape, an elliptical shape, or a polygonal shape, on a cross-section taken along an XY-plane or a plane parallel to the first direction and the second direction, in other words, a cross-section taken along the upper surface or lower surface of the nano-photonic lens array 150. Therefore, each of the plurality of nano-structures NP may have a cylindrical shape, an elliptical pillar shape, or a polygonal pillar shape. A phase profile of the transmitted light, which is implemented by the nano-photonic lens array 150, may be determined according to a size (e.g., width, diameter, or cross-sectional area) and a height of each of the nano-structures NP, and the arrangement period (or pitch) and arrangement type of the plurality of nano-structures NP. Also, the behavior of the light passing through the nano-photonic lens array 150 may be determined according to the phase profile of the transmitted light. For example, the plurality of nano-structures NP may be disposed so as to form a phase profile allowing the light transmitted through the nano-photonic lens array 150 to condense.

The nano-structures NP may each have a size that is less than a wavelength of visible light. The nano-structures NP may have a size that is less than, for example, the blue wavelength. For example, the cross-sectional width (or diameter) of the nano-structures NP may be less than 400 nm, 300 nm, or 200 nm. A height of the nano-structures NP may be about 500 nm to about 1500 nm, and may be greater than the cross-sectional width of the nano-structures NP.

The nano-structures NP may include a material having a relatively higher refractive index as compared with a peripheral material and having a relatively lower absorption ratio in the visible ray band. For example, the nano-structures NP may include c-Si, p-Si, a-Si and a Group III-V compound semiconductor (GaP, GaN, GaAs etc.), SiC, TiO₂, SiN₃, ZnS, ZnSe, Si₃N₄, and/or a combination thereof. Periphery of the nano-structures NP may be filled with the dielectric layer DL having a relatively lower refractive index as compared with the nano-structures NP and have a relatively low absorbent ratio in the visible ray band. For example, the periphery of the nano-structures NP may be filled with a dielectric layer DL including siloxane-based spin on glass (SOG), SiO₂, Si₃N₄, Al₂O₃, air, etc.

The refractive index of the nano-structures NP may be about 2.0 or greater with respect to light of about a 630 nm wavelength, and the refractive index of the dielectric layer DL may be about 1.0 to about 2.0 or less with respect to light of about a 630 nm wavelength. For example, a difference between the refractive indexes of the nano-structures NP and the refractive index of the dielectric layer DL may be about 0.5 or greater. The nano-structures NP having a difference in a refractive index between the refractive index of the peripheral material may change the phase of light that passes through the nano-structures NP. This is caused by phase delay that occurs due to the shape dimension of the sub-wavelength of the nanostructures NP, and a degree at which the phase is delayed, may be determined by a detailed shape dimension and arrangement shape of the nanostructures NP.

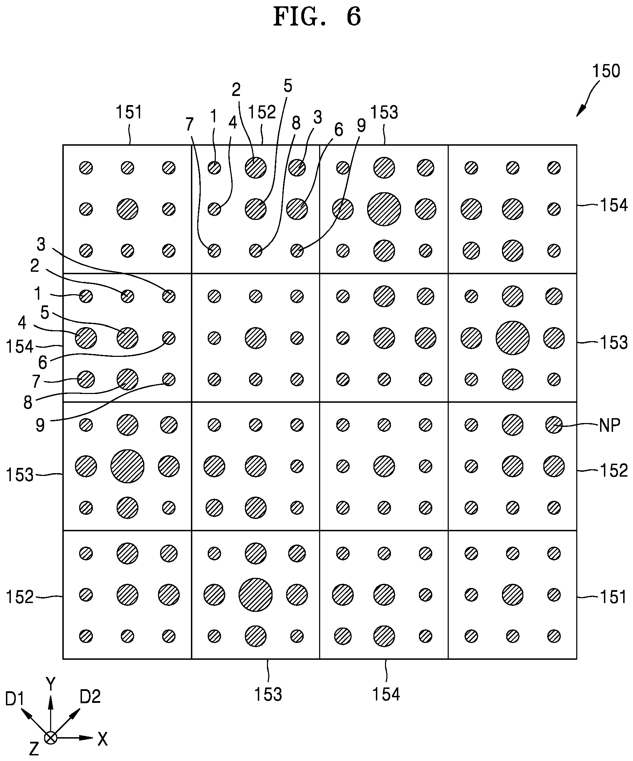

In order to color-separate the incident light into the light of the first wavelength, the light of the second wavelength, and the light of the third wavelength and condense the light onto the corresponding pixels, the plurality of nano-structures NP may be disposed in different types in the first to fourth pixel corresponding regions 151, 152, 153, and 154 of the nano-photonic lens array 150. FIG. 6 is a plan view showing an example of the arrangement of the plurality of nano-structures NP in the nano-photonic lens array 150 shown in FIG. 3. In particular, FIG. 6 shows an example in which nine nano-structures NP are two-dimensionally disposed in a 3x3 array shape in each of the first to fourth pixel corresponding regions 151, 152, 153, and 154.

Referring to FIG. 6, in the first to fourth pixel corresponding regions 151, 152, 153, and 154, positions, materials, and heights of the plurality of nano-structures NP are the same as each other, but the nano-structures NP may have different cross-sectional areas. FIG. 6 shows an example, in which the plurality of nano-structures NP have circular cross-sections on the plane parallel to the first and second directions, that is, the plurality of nano-structures NP have cylindrical pillar shapes, but one or more embodiments are not limited thereto. On the plane parallel to the first and second directions, the plurality of nano-structures NP may have circular cross-sections, elliptical cross-sections, or polygonal cross-sections such as rectangular cross-sections. Hereinafter, the cross-sectional area of each of the plurality of nano-structures NP may be defined as an area of the cross-section of each of the plurality of nano-structures NP taken along the plane parallel to the first and second directions. In each of the first to fourth pixel corresponding regions 151, 152, 153, and 154, distribution of the cross-sectional areas of the plurality of nano-structures NP may be selected in consideration of the relative arrangement relationship among the above-described pixels with reference to FIG. 2A.

For example, because the pixels around the red pixel R and the blue pixel B in FIG. 2A are disposed symmetrically in the first and second directions, in the first pixel corresponding region 151 corresponding to the first pixel 111 that is the red pixel and in the third pixel corresponding region 153 corresponding to the third pixel 113 that is the blue pixel, the cross-sectional areas of the plurality of nano-structures NP may be distributed symmetrically in the first direction and the second direction. Also, in the first pixel corresponding region 151 and the third pixel corresponding region 153, the cross-sectional areas of the plurality of nano-structures NP may be distributed symmetrically in the first diagonal direction D1 and the second diagonal direction D2. In this point of view, it may be considered that the plurality of nano-structures NP are disposed in a 4-fold symmetry in the first pixel corresponding region 151 and the third pixel corresponding region 153.

For example, as shown in FIG. 6, from among the nano-structures NP in the first pixel corresponding region 151, the nano-structure located at the center of the first pixel corresponding region 151 has largest cross-sectional area, and eight nano-structures located in the periphery portion of the first pixel corresponding region 151 may have the cross-sectional areas that are less than that of the nano-structure at the center and may be equal to one another, when the nano-structures NP are viewed from the top. Also, from among the nano-structures NP in the third pixel corresponding region 153, the nano-structure located at the center of the third pixel corresponding region 153 has largest cross-sectional area, four nano-structures located around the centers in four sides of the third pixel corresponding region 153 may have cross-sectional areas that are less than that of the nano-structure at the center and may be equal to one another, and four nano-structures located around apexes of the third pixel corresponding region 153 may have smallest cross-sectional areas that are equal to one another. Also, the cross-sectional area of the nano-structure located at the center of the third pixel corresponding region 153 may be greater than that of the nano-structure located at the center of the first pixel corresponding region 151. Therefore, in each of the first pixel corresponding region 151 and the third pixel corresponding region 153, two nano-structures corresponding to each other in the first direction may have the same cross-sectional area, two nano-structures corresponding to each other in the second direction may have the same cross-sectional area, two nano-structures corresponding to each other in the first diagonal direction D1 may have the same cross-sectional area, and two nano-structures corresponding to each other in the second diagonal direction D2 may have the same cross-sectional area.

In addition, in FIG. 2A, the pixels around the first green pixel G1 and the second green pixel G2 are disposed asymmetrically in the first direction, the second direction, and the first diagonal direction D1 and symmetrically in the second diagonal direction D2. Thus, in the second pixel corresponding region 152 corresponding to the second pixel 112 that is the first green pixel and the fourth pixel corresponding region 154 corresponding to the fourth pixel 114 that is the second green pixel, the cross-sectional areas of the plurality of nano-structures NP are disposed asymmetrically in the first direction, the second direction, and the first diagonal direction D1 and symmetrically in the second diagonal direction D2. Also, because the red pixel R and the blue pixel B are exchanged with each other in the pixel arrangement around the first green pixel G1 and the pixel arrangement around the second green pixel G2 in FIG. 2A, the distribution of the cross-sectional areas of the plurality of nano-structures NP in the second pixel corresponding region 152 and the distribution of the cross-sectional areas of the plurality of nano-structures NP in the fourth pixel corresponding region 154 are mirror-symmetrical with each other in the first diagonal direction D1.

For example, from among nine nano-structures NP disposed in a 3x3 array, when the nano-structures in the first row are referred to as first to third nano-structures 1, 2, and 3 from left to right, the nano-structures in the second row are referred to as fourth to sixth nano-structures 4, 5, and 6 from left to right, and the nano-structures in the third row are referred to seventh to ninth nano-structures 7, 8, and 9 from left to right, the second, fifth, and sixth nano-structures 2, 5, and 6 may have largest cross-sectional areas from among the nano-structures NP in the second pixel corresponding region 152. In addition, the cross-sectional area of the third nano-structure 3 may be less than those of the second, fifth, and sixth nano-structures 2, 5, and 6, and the first, fourth, seventh, eighth, and ninth nano-structures 1, 4, 7, 8, and 9 may have smallest cross-sectional areas.

Therefore, pairs of two nano-structures corresponding to each other in the first direction in the second pixel corresponding region 152, that is, at least one pair from among the pairs of the first and third nano-structures 1 and 3, the fourth and sixth nano-structures 4 and 6, and the seventh and ninth nano-structures 7 and 9 may have different cross-sectional areas from each other. Also, from among the pairs of two nano-structures corresponding to each other in the second direction in the second pixel corresponding region 152, that is, the first and seventh nano-structures 1 and 7, the second and eighth nano-structures 2 and 8, and the third and ninth nano-structures 3 and 9, at least one pair may have different cross-sectional areas from each other. Also, from among the pairs of two nano-structures corresponding to each other in the second diagonal direction D2 in the second pixel corresponding region 152, that is, the second and fourth nano-structures 2 and 4, the third and seventh nano-structures 3 and 7, and the sixth and eighth nano-structures 6 and 8, at least one pair may have different cross-sectional areas from each other. On the contrary, the pairs of two nano-structures corresponding to each other in the first diagonal direction D1 in the second pixel corresponding region 152, that is, the first and ninth nano-structures 1 and 9, the second and sixth nano-structures 2 and 6, and the fourth and eighth nano-structures 4 and 8 may have the same cross-sectional areas.

From among the nano-structures NP in the fourth pixel corresponding region 154, the fourth, fifth, and eighth nano-structures 4, 5, and 8 have largest cross-sectional areas, the cross-sectional area of the seventh nano-structure 7 may be less than those of the fourth, fifth, and eighth nano-structures 4, 5, and 8, and the first, second, third, sixth, and ninth nano-structures 1, 2, 3, 6, and 9 may have smallest cross-sectional areas. Therefore, pairs of two nano-structures corresponding to each other in the first direction in the fourth pixel corresponding region 154, that is, at least one pair from among the pairs of the first and third nano-structures 1 and 3, the fourth and sixth nano-structures 4 and 6, and the seventh and ninth nano-structures 7 and 9 may have different cross-sectional areas from each other. Also, from among the pairs of two nano-structures corresponding to each other in the second direction in the fourth pixel corresponding region 154, that is, the first and seventh nano-structures 1 and 7, the second and eighth nano-structures 2 and 8, and the third and ninth nano-structures 3 and 9, at least one pair may have different cross-sectional areas from each other. Also, from among the pairs of two nano-structures corresponding to each other in the second diagonal direction D2 in the fourth pixel corresponding region 154, that is, the second and fourth nano-structures 2 and 4, the third and seventh nano-structures 3 and 7, and the sixth and eighth nano-structures 6 and 8, at least one pair may have different cross-sectional areas from each other. On the contrary, the pairs of two nano-structures corresponding to each other in the first diagonal direction D1 in the fourth pixel corresponding region 154, that is, the first and ninth nano-structures 1 and 9, the second and sixth nano-structures 2 and 6, and the fourth and eighth nano-structures 4 and 8 may have the same cross-sectional areas.

Also, the cross-sectional area of each of the plurality of nano-structures NP in the second pixel corresponding region 152 may be equal to that of the nano-structure NP in the fourth pixel corresponding region 154 which is positioned symmetrically with the nano-structures NP in the second pixel corresponding region 152 in the first diagonal direction D1. For example, the cross-sectional area of the first nano-structure 1 in the second pixel corresponding region 152 and the cross-sectional area of the first nano-structure 1 in the fourth pixel corresponding region 154 are the same as each other, the cross-sectional area of the second nano-structure 2 in the second pixel corresponding region 152 and the cross-sectional area of the fourth nano-structure 4 in the fourth pixel corresponding region 154 are the same as each other, the cross-sectional area of the third nano-structure 3 in the second pixel corresponding region 152 and the cross-sectional area of the seventh nano-structure 7 in the fourth pixel corresponding region 154 are the same as each other, the cross-sectional area of the fourth nano-structure 4 in the second pixel corresponding region 152 and the cross-sectional area of the second nano-structure 2 in the fourth pixel corresponding region 154 are the same as each other, the cross-sectional area of the fifth nano-structure 5 in the second pixel corresponding region 152 and the cross-sectional area of the fifth nano-structure 5 in the fourth pixel corresponding region 154 are the same as each other, the cross-sectional area of the sixth nano-structure 6 of the second pixel corresponding region 152 and the cross-sectional area of the eighth nano-structure 8 in the fourth pixel corresponding region 154 are the same as each other, the cross-sectional area of the seventh nano-structure 7 in the second pixel corresponding region 152 and the cross-sectional area of the third nano-structure 3 in the fourth pixel corresponding region 154 are the same as each other, the cross-sectional area of the eighth nano-structure 8 in the second pixel corresponding region 152 and the cross-sectional area of the sixth nano-structure 6 in the fourth pixel corresponding region 154 are the same as each other, and the cross-sectional area of the ninth nano-structure 9 in the second pixel corresponding region 152 and the cross-sectional area of the ninth nano-structure 9 in the fourth pixel corresponding region 154 are the same as each other.

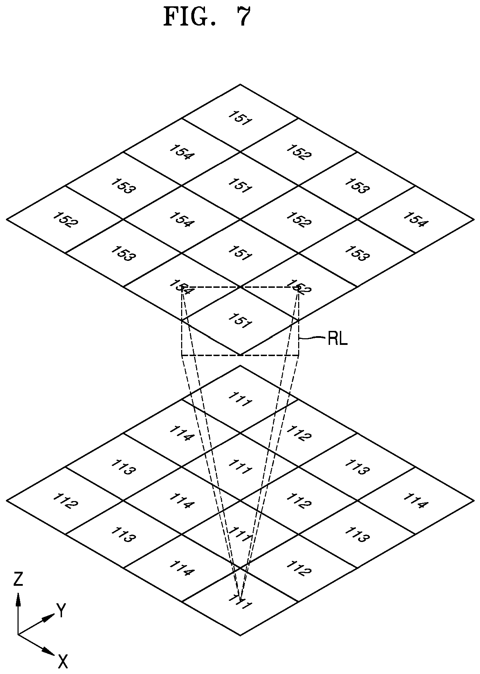

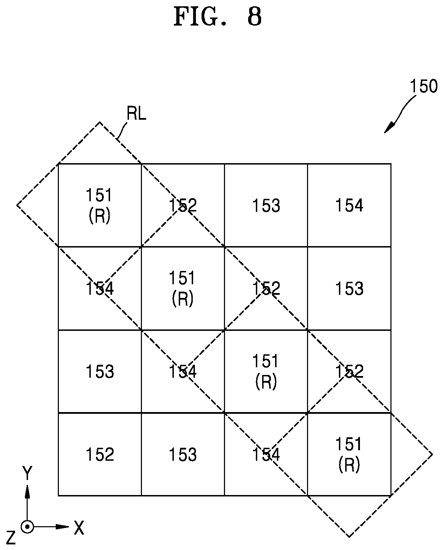

FIG. 7 is a diagram showing an example of passage of red light incident on a periphery of the first pixel corresponding region 151 in the nano-photonic lens array 150. Also, FIG. 8 shows an example of an array of red light condensing regions RL formed by the nano-photonic lens array 150.

Referring to FIG. 7, the nano-photonic lens array 150 condenses red light onto the first pixel 111 from the following sources: an incident light anywhere on the first pixel corresponding region 151, and an incident light on specific portions of the second pixel corresponding region 152 and the fourth pixel corresponding region 154. In other words, among the incident light incident anywhere on the first pixel corresponding region 151 and the incident light incident on a specific portion of the second pixel corresponding region 152 and a specific portion of the fourth pixel corresponding region 154, the red light is condensed to the first pixel 111 by the nano-photonic lens array 150. In detail, the red light that has passed through a rectangular region formed by connecting the centers of two second pixel corresponding regions 152 that are adjacent to the first pixel corresponding region 151 while contacting one sides thereof and the centers of two fourth pixel corresponding regions 154 that are adjacent to the first pixel corresponding region 151, while contacting one sides thereof, may be condensed onto the first pixel 111 by the nano-photonic lens array 150. The rectangular region may be referred to as a red light condensing region RL. For example, the first pixel corresponding region 151 and the red light condensing region RL that surrounds the first pixel corresponding region 151 may be a concentric pair of squares, wherein the red light condensing region RL is rotated through 45° with respect to the first pixel corresponding region 151, and vertices of the first pixel corresponding region 151 lie on the edges of the red light condensing region RL, at the midpoints of the edges of the red light condensing region RL. Therefore, as shown in FIG. 8, the nano-photonic lens array 150 may operate as an array of a plurality of red light condensing regions RL condensing the red light respectively onto the plurality of first pixels 111. An area of each red light condensing region RL may be, for example, 1.5 to two times greater than an area of the first pixel 111 corresponding thereto.

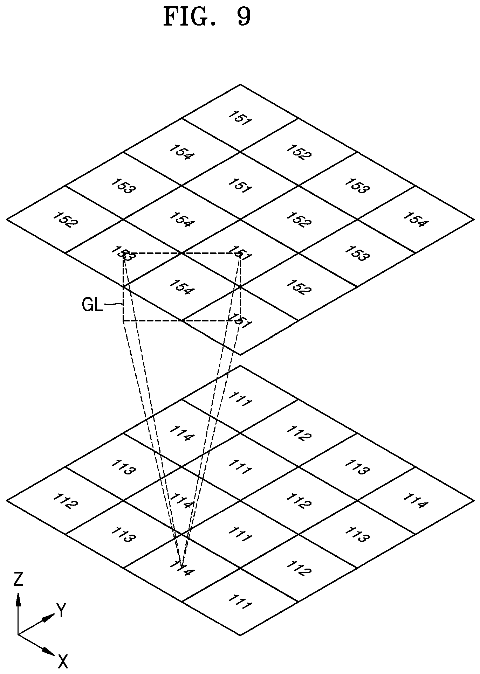

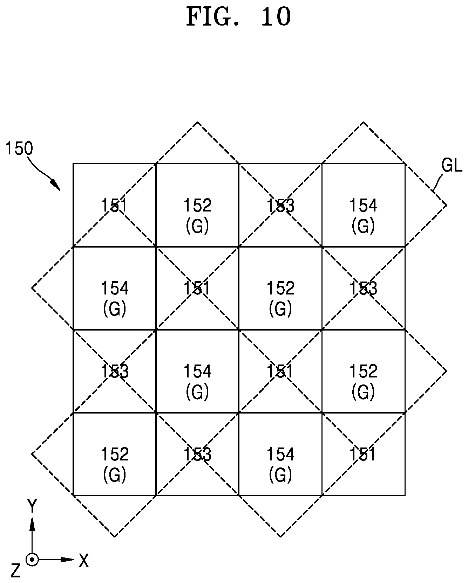

FIG. 9 is a diagram showing an example of passage of the green light incident on the periphery of the fourth pixel corresponding region 154 of the nano-photonic lens array 150. Also, FIG. 10 shows an example of an array of green light condensing regions formed by the nano-photonic lens array 150.

Referring to FIG. 9, the nano-photonic lens array 150 condenses green light onto the fourth pixel 114 from the following sources: an incident light anywhere on the fourth pixel corresponding region 154, and an incident light on specific portions of the first pixel corresponding region 151 and the third pixel corresponding region 153. In other words, among the incident light incident on the fourth pixel corresponding region 154 and the incident light incident on a specific portion of the first pixel corresponding region 151 and a specific portion of the third pixel corresponding region 153, the green light is condensed onto the fourth pixel 114 by the nano-photonic lens array 150. In detail, the green light that has passed through the rectangular region formed by connecting the centers of two first pixel corresponding regions 151 that are adjacent to the fourth pixel corresponding region 154 while contacting one sides thereof and the centers of two third pixel corresponding regions 153 that are adjacent to the fourth pixel corresponding region 154 while contacting one sides thereof may be condensed onto the fourth pixel 114 by the nano-photonic lens array 150. Likewise, among the incident light that is incident on the second pixel corresponding region 152 and the incident light that is incident on a portion of the first pixel corresponding region 151 and a portion of the third pixel corresponding region 153 around the second pixel corresponding region 152, the green light may be condensed onto the second pixel 112 by the nano-photonic lens array 150. That is, the green light that passed through the rectangular region obtained by connecting the centers of two first pixel corresponding regions 151 that are adjacent to the second pixel corresponding region 152 while contacting one sides thereof and the centers of two third pixel corresponding regions 153 that are adjacent to the second pixel corresponding region 152 while contacting one sides thereof may be condensed onto the second pixel 112 by the nano-photonic lens array 150. In this point, the rectangular region obtained by connecting the centers of two first pixel corresponding regions 151 that are adjacent to the second pixel corresponding region 152 or the fourth pixel corresponding region 154 while contacting one sides thereof and the centers of two third pixel corresponding regions 153 that are adjacent to the second pixel corresponding region 152 or the fourth pixel corresponding region 154 while contacting one sides thereof may be a green light condensing region GL. Therefore, as shown in FIG. 10, the nano-photonic lens array 150 may operate as an array of a plurality of green light condensing regions GL that respectively condense the green light onto the plurality of second pixels 112 and the plurality of fourth pixels 114. An area of each green light condensing region GL may be, for example, 1.5 to two times greater than that of the corresponding second pixel 112 or the fourth pixel 114. A green light incident at any position within the green light condensing regions GL of the nano-photonic lens array 150 may be focused on green pixels (e.g., the fourth pixels 114 which are positioned directly below the fourth pixel corresponding region 154).

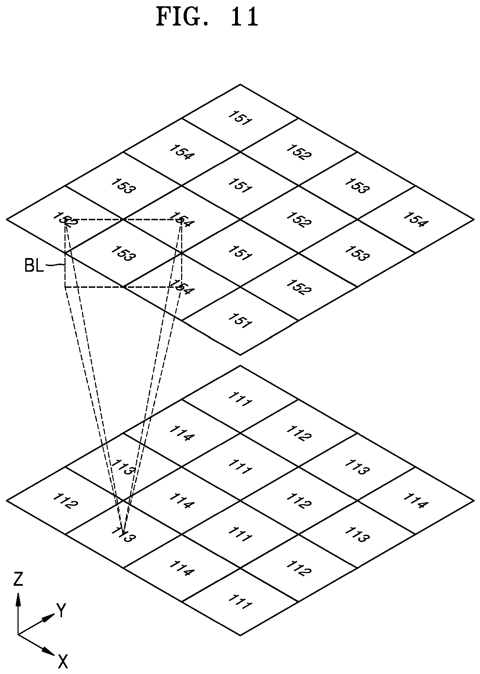

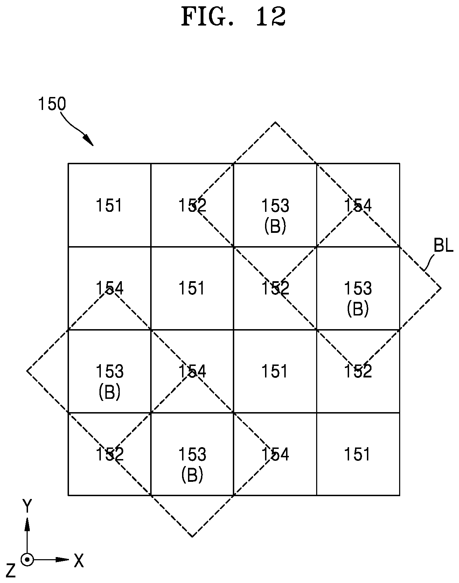

FIG. 11 shows an example of passage of blue light incident on a periphery of the third pixel corresponding region 153 in the nano-photonic lens array 150. Also, FIG. 12 shows an example of an array of blue light condensing regions BL formed by the nano-photonic lens array 150.

Referring to FIG. 11, the nano-photonic lens array 150 condenses blue light onto the third pixel 113 from the following sources: an incident light anywhere on the third pixel corresponding region 153, and an incident light on specific portions of the second pixel corresponding region 152 and the fourth pixel corresponding region 154. In other words, among the incident light incident on the third pixel corresponding region 153 and the incident light incident on a specific portion of the second pixel corresponding region 152 and a specific portion of the fourth pixel corresponding region 154, the blue light is condensed onto the third pixel 113 by the nano-photonic lens array 150. In detail, the blue light that has passed through a rectangular region formed by connecting the centers of two second pixel corresponding regions 152 that are adjacent to the third pixel corresponding region 153 while contacting one sides thereof and the centers of two fourth pixel corresponding regions 154 that are adjacent to the third pixel corresponding region 153 while contacting one sides thereof may be condensed onto the third pixel 113 by the nano-photonic lens array 150. In this point, the rectangular region obtained by connecting the centers of two second pixel corresponding regions 152 that are adjacent to the third pixel corresponding region 153 while contacting one sides thereof and the centers of two fourth pixel corresponding regions 154 that are adjacent to the third pixel corresponding region 153 while contacting one sides thereof may be the blue light condensing region BL. For example, the third pixel corresponding region 153 and the blue light condensing region BL that surrounds the third pixel corresponding region 153 may be a concentric pair of squares, wherein the blue light condensing region BL is rotated through 45° with respect to the third pixel corresponding region 153, and vertices of the third pixel corresponding region 153 lie on the edges of the blue light condensing region BL, at the midpoints of the edges of the blue light condensing region BL. As shown in FIG. 12, the nano-photonic lens array 150 may operate as an array of a plurality of blue light condensing regions BL condensing the blue light respectively onto the plurality of third pixels 113. An area of each blue light condensing region BL may be, for example, 1.5 to two times greater than an area of the third pixel 113 corresponding thereto. A blue light incident at any position within the blue light condensing regions BL of the nano-photonic lens array 150 may be focused on blue pixels (e.g., the third pixels 113 which are positioned directly below the third pixel corresponding region 153).

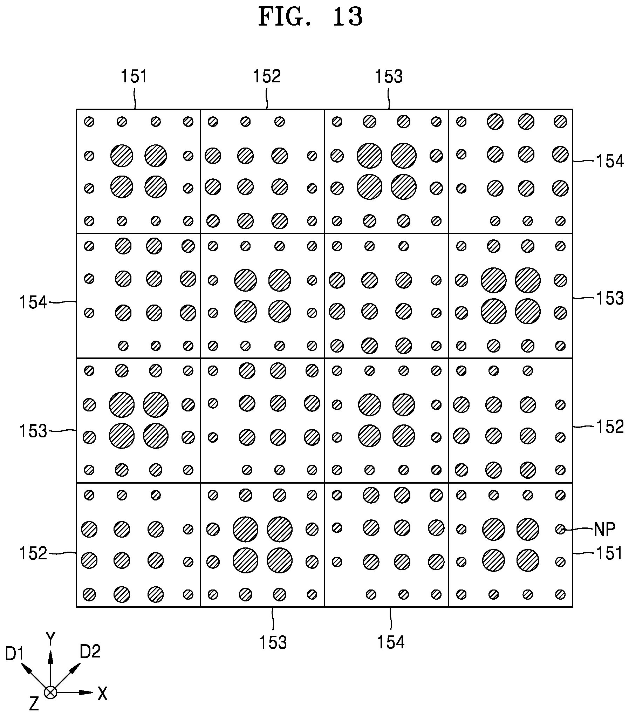

In addition, FIG. 6 shows an example in which nine nano-structures NP are two-dimensionally disposed in a 3x3 array in each of the first to fourth pixel corresponding regions 151, 152, 153, and 154, but the arrangement of the nano-structures NP is not limited thereto. That is, the nano-structures NP may be disposed in various other types. FIG. 13 is a plan view showing an example of an arrangement of the plurality of nano-structures NP in the nano-photonic lens array 150 according to another embodiment. In particular, FIG. 13 shows an example in which sixteen nano-structures NP are two-dimensionally disposed in a 4x4 array in each of the first to fourth pixel corresponding regions 151, 152, 153, and 154.

When the nano-structures NP are disposed in the 4x4 array, the arrangement rule of the nano-structures NP described above with reference to FIG. 6 may be also applied. That is, in the first pixel corresponding region 151 and the third pixel corresponding region 153, the cross-sectional areas of the plurality of nano-structures NP may be distributed symmetrically in the first direction, the second direction, the first diagonal direction D1, and the second diagonal direction D2. For example, from among the nano-structures NP in the first pixel corresponding region 151, the four nano-structures located at the center of the first pixel corresponding region 151 have largest cross-sectional areas, and twelve nano-structures located in the periphery portion of the first pixel corresponding region 151 may have the cross-sectional areas that are less than those of the nano-structures at the center and may be equal to one another. Also, from among the nano-structures NP in the third pixel corresponding region 153, four nano-structures located at the center of the third pixel corresponding region 153 has largest cross-sectional area, eight nano-structures located around the centers in four sides of the third pixel corresponding region 153 may have cross-sectional areas that are less than that of the nano-structure at the center and may be equal to one another, and four nano-structures located around apexes of the third pixel corresponding region 153 may have smallest cross-sectional areas that are equal to one another. Also, the cross-sectional areas of the four nano-structures located at the center of the third pixel corresponding region 153 may be greater than those of the four nano-structures located at the center of the first pixel corresponding region 151.

The cross-sectional areas of the plurality of nano-structures NP in the second pixel corresponding region 152 and the fourth pixel corresponding region 154 are distributed asymmetrically in the first direction, the second direction, and the first diagonal direction D1 and symmetrically in the second diagonal direction D2. Also, the distribution of the cross-sectional areas of the plurality of nano-structures NP in the second pixel corresponding region 152 and the distribution of the cross-sectional areas of the plurality of nano-structures NP in the fourth pixel corresponding region 154 are mirror-symmetrical with each other in the first diagonal direction D1. For example, from among the plurality of nano-structures NP in the second pixel corresponding region 152 and the fourth pixel corresponding region 154, four nano-structures located at each center portion and four nano-structures disposed around the centers in the two sides facing the first pixel corresponding region 151 may have first cross-sectional areas that are the largest. Also, one nano-structure disposed at an apex facing two first pixel corresponding regions 151 may have a second cross-sectional area that is less than the first cross-sectional area. Also, from among the plurality of nano-structures NP in the second pixel corresponding region 152 and the fourth pixel corresponding region 154, four nano-structures disposed around the centers of two sides facing the third pixel corresponding region 153 and two nano-structures disposed at two apexes facing the first pixel corresponding region 151 and the third pixel corresponding region 153 may each have a third cross-sectional area that is less than the second cross-sectional area. Also, one nano-structure disposed at an apex facing two third pixel corresponding regions 153 may have a fourth cross-sectional area less than the third cross-sectional area. For example, the fourth cross-sectional area may be 0 (zero).

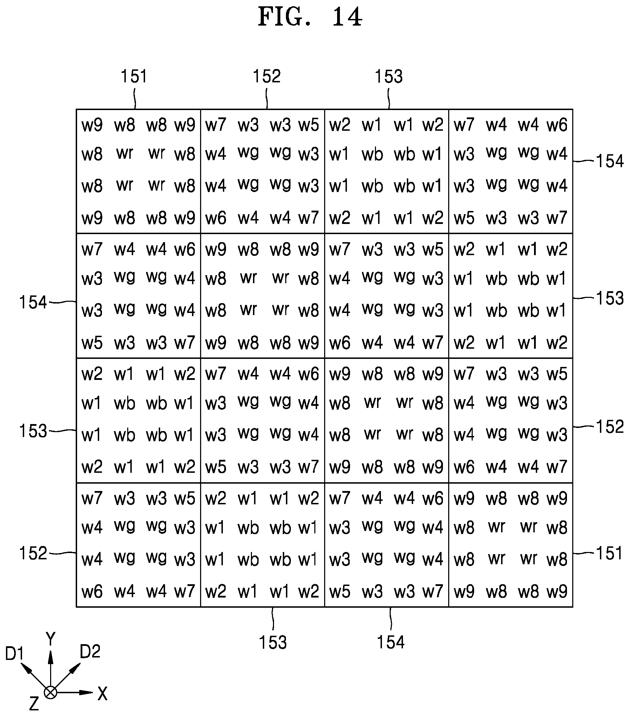

The cross-sectional areas of the nano-structures NP shown in the example of FIG. 13 are just an example for convenience of description, and the cross-sectional areas of the nano-structures NP may be differently selected according to sizes of the first to fourth pixels 111, 112, 113, and 114 in the image sensor 1000 and color characteristics of the image sensor 1000. However, in order to optimize operations for setting cross-sectional areas of the nano-structures NP, inner portions of the first to fourth pixel corresponding regions 151, 152, 153, and 154 may be divided into a plurality of sections so that the cross-sectional areas of the nano-structures NP in the same section may be the same as one another. FIG. 14 is a diagram showing an example of a variable condition for selecting cross-sectional areas of the nano-structures NP according to positions thereof in the nano-photonic lens array 150 of FIG. 13.

Referring to FIG. 14, conditions may be selected so that the first pixel corresponding region 151 and the third pixel corresponding region 153 may be symmetrical in the first direction and the second direction. For example, in each of the first pixel corresponding region 151 and the third pixel corresponding region 153, the cross-sectional areas of four nano-structures located at the center portion are equal to one another, the cross-sectional areas of eight nano-structures located around the centers of the four sides are equal to one another, and the cross-sectional areas of four nano-structures located around the apexes may be the same as one another. In the first pixel corresponding region 151, wr, w8, and w9 are variables having numerical values about the cross-sectional areas of the nano-structures NP, and numerical values of wr, w8, and w9 may be independently determined through calculations. The nano-structures NP to which the same variable is assigned may have the same cross-sectional areas. However, it is possible that different variables may not necessarily have different numerical values, and according to the calculation result, two or more variables from among wr, w8, and w9 may accidentally have the same value. Also, an order of sizes among wr, w8, and w9 may be different from the example shown in FIG. 13 according to the calculation result. Likewise, in the third pixel corresponding region 153, wb, w1, and w2 are variables having numerical values about the cross-sectional areas of the nano-structures NP, and numerical values of wb, w1, and w2 may be independently determined through the calculation.

Conditions are selected so that the second pixel corresponding region 152 and the fourth pixel corresponding region 154 are asymmetrical with each other in the first direction, the second direction, and the first diagonal direction D1 and symmetrical in the second diagonal direction D2. Also, the conditions are selected so that the second pixel corresponding region 152 and the fourth pixel corresponding region 154 may be mirror-symmetrical with each other in the first diagonal direction D1. For example, the same variable wg may be assigned to four nano-structures located at the center portions of the second pixel corresponding region 152 and the fourth pixel corresponding region 154, the same variable w4 may be assigned to four nano-structures disposed around the centers of two sides facing the first pixel corresponding region 151, the same variable w3 may be assigned to four nano-structures disposed around the centers of two sides facing the third pixel corresponding region 153, the same variable w7 may be assigned to two nano-structures disposed at two apexes facing the first pixel corresponding region 151 and the third pixel corresponding region 153, the variable w6 may be assigned to one nano-structure disposed at the apex facing two first pixel corresponding regions 151, and the variable w5 may be assigned to one nano-structure disposed at the apex facing two third pixel corresponding regions 153. In the second pixel corresponding region 152 and the fourth pixel corresponding region 154, the nano-structures NP to which the same variable is assigned may have the same cross-sectional areas. According to the calculation result, two or more variables from among wg, w3, w4, w5, w6, and w7 may accidentally have the same value.

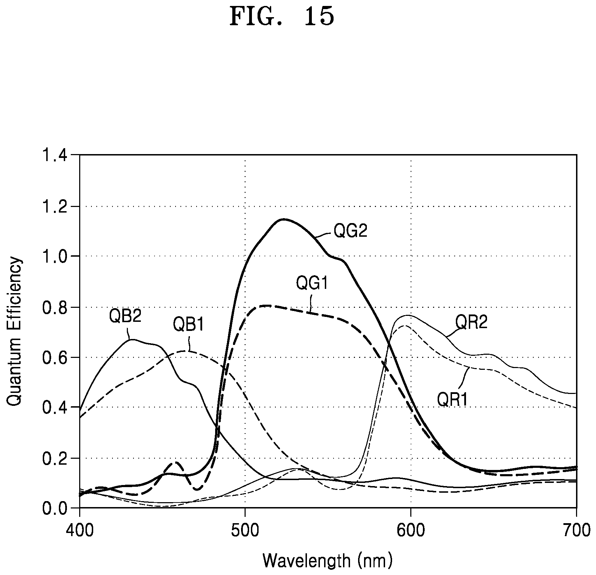

FIG. 15 is a graph showing a light utilization efficiency of the image sensor 1000 including the nano-photonic lens array 150 of FIG. 13 versus that of a comparative example. The comparative example relates to an image sensor including a general color filter. Also, in FIG. 15, QB1, QG1, and QR1 denote quantum efficiencies with respect to blue light, green light, and red light in the image sensor according to the comparative example, and QB2, QG2, and QR2 denote quantum efficiencies with respect to blue light, green light, and red light in the image sensor according to the embodiment. Referring to FIG. 15, the image sensor 1000 including the nano-photonic lens array 150 shown in FIG. 13 may have improved light utilization efficiencies with respect to the blue light, green light, and red light, as compared with the image sensor according to the comparative example.

So far, the description is provided that the arrangements of the plurality of nano-structures NP in the first pixel corresponding region 151 and the third pixel corresponding region 153 are symmetrical with each other in the first direction, the second direction, the first diagonal direction D1, and the second diagonal direction D2, only in consideration of the green pixels around the red pixel R and the blue pixel B. However, because the blue pixel B is disposed in the first diagonal direction D1 of the blue pixel B and the red pixel R is disposed in the second diagonal direction D2 of the blue pixel whereas the red pixel R is disposed in the first diagonal direction D1 of the red pixel R and the blue pixel B is disposed in the second diagonal direction D2 of the red pixel R, there may be a slight difference in the arrangement of the peripheral pixels of the red pixel R and the blue pixel B. In further consideration of the difference in the arrangements, the arrangements of the plurality of nano-structures NP in the first pixel corresponding region 151 and the third pixel corresponding region 153 may be deformed.

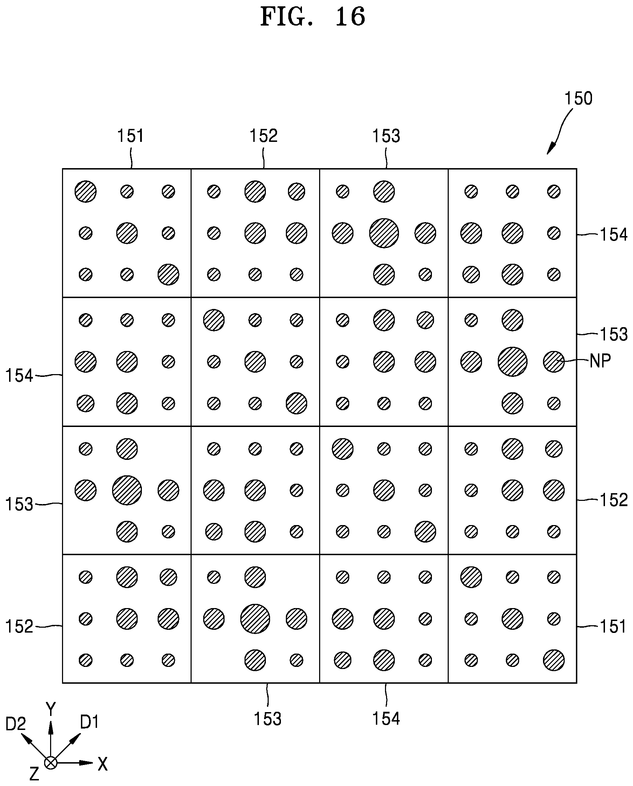

FIG. 16 is a plan view showing an example of an arrangement of the plurality of nano-structures NP in the nano-photonic lens array 150 according to another embodiment. In particular, FIG. 16 shows an example in which nine nano-structures NP are two-dimensionally disposed in a 3x3 array in each of the first to fourth pixel corresponding regions 151, 152, 153, and 154. In FIG. 16, the second pixel corresponding region 152 and the fourth pixel corresponding region 154 are the same as the second pixel corresponding region 152 and the fourth pixel corresponding region 154 shown in FIG. 6. Therefore, descriptions about the second pixel corresponding region 152 and the fourth pixel corresponding region 154 are omitted.

Referring to FIG. 16, the distributions of the cross-sectional areas of the plurality of nano-structures NP in the first pixel corresponding region 151 corresponding to the first pixel 111, that is, the red pixel, and in the third pixel corresponding region 153 corresponding to the third pixel 113, that is, the blue pixel, are asymmetrical in the first direction and the second direction and may be symmetrical in the first diagonal direction D1 and the second diagonal direction D2. For example, from among the nano-structures NP in the first pixel corresponding region 151, three nano-structures disposed in the second diagonal direction D2 passing through the center portion of the first pixel corresponding region 151 have the largest cross-sectional areas, and the cross-sectional areas of remaining six nano-structures may be less than those of the nano-structures at the center portion and equal to one another. Also, from among the nano-structures NP in the third pixel corresponding region 153, the nano-structure located at the center portion of the third pixel corresponding region 153 has largest cross-sectional area, four nano-structures located around the centers in four sides of the third pixel corresponding region 153 may have cross-sectional areas that are less than that of the nano-structure at the center portion and may be equal to one another, the cross-sectional areas of two nano-structures located around the apex of the third pixel corresponding region 153 in the second diagonal direction D2 may be less than those of four nano-structures located around the centers of the sides and equal to each other, and two nano-structures located around the apex of the third pixel corresponding region 153 in the first diagonal direction D1 may have smallest cross-sectional areas. In particular, the cross-sectional areas of two nano-structures located around the apex of the third pixel corresponding region 153 in the first diagonal direction D1 may be 0 (zero).

Therefore, in the first pixel corresponding region 151 and the third pixel corresponding region 153, at least one of the pairs of two nano-structures corresponding to each other in the first direction may have different cross-sectional areas and at least one of the pairs of two nano-structures corresponding to each other in the second direction may have different cross-sectional areas. Also, in the first pixel corresponding region 151 and the third pixel corresponding region 153, the pairs of two nano-structures corresponding to each other in the first diagonal direction D1 may have the same cross-sectional areas, and the pairs of two nano-structures corresponding to each other in the second diagonal direction D2 may have the same cross-sectional areas.

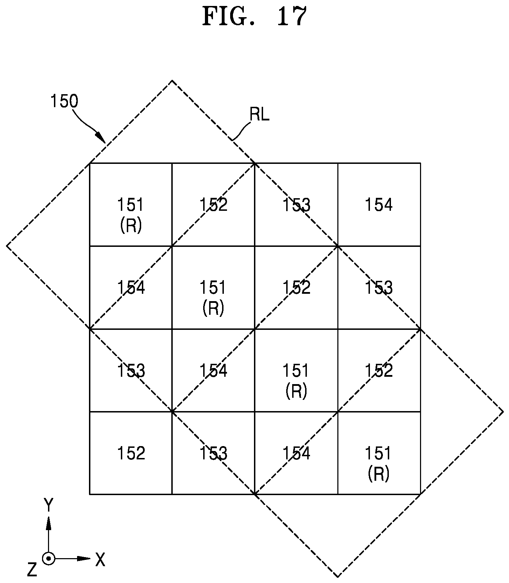

FIGS. 17 to 19 are diagrams showing examples of arrangement type of a red light condensing region, a green light condensing region, and a blue light condensing region in the nano-photonic lens array 150 of FIG. 16.

Referring to FIG. 17, the red light condensing region RL may be a rectangular region obtained by connecting the apexes of two second pixel corresponding regions 152 and the apexes of two fourth pixel corresponding regions 154 that are adjacent to the first pixel corresponding region 151 while contacting one sides thereof. In particular, the red light condensing region RL may be a region connecting the apexes facing the two third pixel corresponding regions 153, from among the apexes of the second pixel corresponding region 152 and the fourth pixel corresponding region 154 around the first pixel corresponding region 151. That is, the red light that passed through the region obtained by connecting the apexes facing the two third pixel corresponding regions 153, from among the apexes of the second and fourth pixel corresponding regions 152 and 154, may be condensed onto the first pixel 111 by the nano-photonic lens array 150. Therefore, the red light condensing region RL shown in FIG. 17 may be greater than the red light condensing region RL shown in FIGS. 7 and 8. For example, an area of the red light condensing region RL shown in FIG. 17 may be three to four times greater than that of the corresponding first pixel 111. Therefore, by adopting the nano-photonic lens array 150 shown in FIG. 16, the light utilization efficiency of the red light in the image sensor may be further improved.

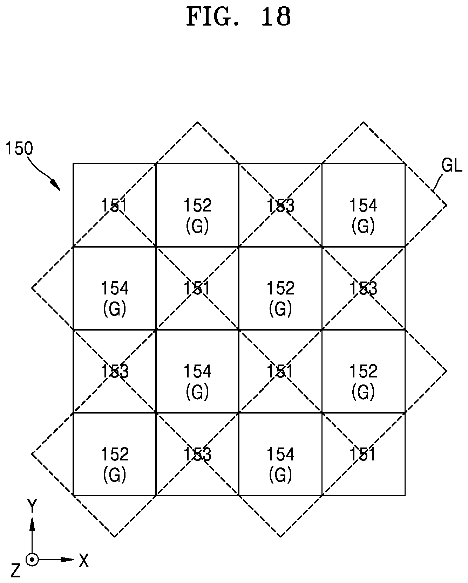

Referring to FIG. 18, the green light condensing region GL of FIG. 18 may be the same as the green light condensing region GL shown in FIGS. 9 and 10.

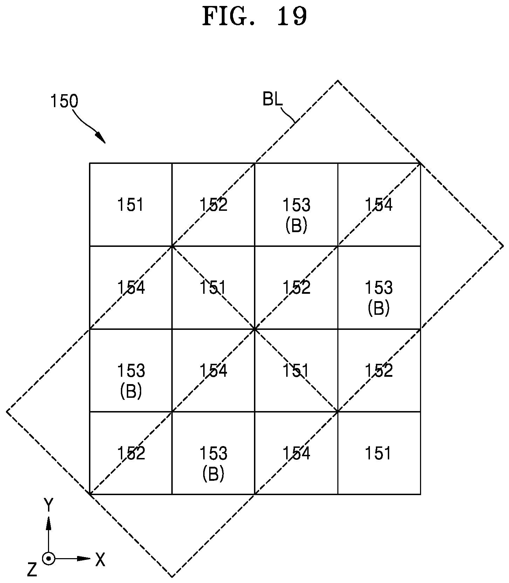

Referring to FIG. 19, the blue light condensing region BL may be a rectangular region obtained by connecting the apexes of two second pixel corresponding regions 152 to the apexes of two fourth pixel corresponding regions 154 that are adjacent to the third pixel corresponding region 153 while contacting one sides thereof. In particular, the blue light condensing region BL may be a region connecting the apexes facing the two first pixel corresponding regions 151, from among the apexes of the second pixel corresponding region 152 and the fourth pixel corresponding region 154 around the third pixel corresponding region 153. That is, the blue light that passed through the region obtained by connecting the apexes facing the two first pixel corresponding regions 151, from among the apexes of the second and fourth pixel corresponding regions 152 and 154, may be condensed onto the third pixel 113 by the nano-photonic lens array 150. Therefore, the blue light condensing region BL shown in FIG. 19 may be greater than the blue light condensing region BL shown in FIGS. 11 and 12. For example, an area of the blue light condensing region BL shown in FIG. 19 may be three to four times greater than that of the corresponding third pixel 113. Therefore, by adopting the nano-photonic lens array 150 shown in FIG. 16, the light utilization efficiency of the blue light in the image sensor may be further improved.

The image sensor 1000 may have an improved light utilization efficiency. As the light utilization efficiency is improved, a size of one pixel or size of independent photosensitive cells in the pixel of the image sensor 1000 may be reduced. Therefore, the ultra-fine pixel image sensor 1000 having high resolution may be provided. According to the embodiment, the nano-photonic lens array 150 may be applied to the image sensor 1000 along with the pixel arrangement that does not need the demosaic process when using a binning mode. Therefore, the image sensor 1000 may exhibit an increase in the sensitivity, improvement in a resolution, and improvement in the power consumption under the low-illuminance, while having ultra-fine pixels. The image sensor 1000 according to the embodiment may form a camera module along with a module lens of various functions and may be utilized in various electronic devices.

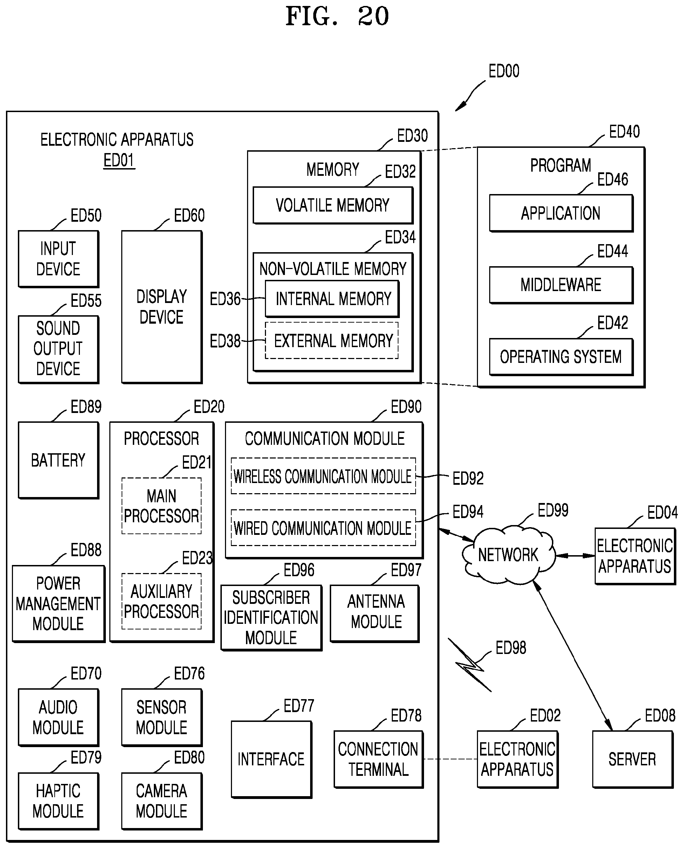

FIG. 20 is a block diagram showing an example of an electronic apparatus ED01 including the image sensor 1000. Referring to FIG. 20, in a network environment ED00, the electronic apparatus ED01 may communicate with another electronic apparatus ED02 via a first network ED98 (short-range wireless communication network, etc.), or may communicate with another electronic apparatus ED04 and/or a server ED08 via a second network ED99 (long-range wireless communication network, etc.) The electronic apparatus ED01 may communicate with the electronic apparatus ED04 via the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic apparatus ED01, some (display device ED60, etc.) of the elements may be omitted or another element may be added. Some of the elements may be configured as one integrated circuit. For example, the sensor module ED76 (a fingerprint sensor, an iris sensor, an illuminance sensor, etc.) may be embedded and implemented in the display device ED60 (display, etc.).

The processor ED20 may control one or more elements (hardware, software elements, etc.) of the electronic apparatus ED01 connected to the processor ED20 by executing software (program ED40, etc.), and may perform various data processes or operations. As a portion of the data processing or operations, the processor ED20 may load a command and/or data received from another element (sensor module ED76, communication module ED90, etc.) to a volatile memory ED32, may process the command and/or data stored in the volatile memory ED32, and may store result data in a non-volatile memory ED34. The non-volatile memory ED34 may include an internal memory ED36 and an external memory ED38. The processor ED20 may include a main processor ED21 (central processing unit, application processor, etc.) and an auxiliary processor ED23 (graphic processing unit, image signal processor, sensor hub processor, communication processor, etc.) that may be operated independently from or along with the main processor ED21. The auxiliary processor ED23 may use less power than that of the main processor ED21, and may perform specified functions.

The auxiliary processor ED23, on behalf of the main processor ED21 while the main processor ED21 is in an inactive state (sleep state) or along with the main processor ED21 while the main processor ED21 is in an active state (application executed state), may control functions and/or states related to some (display device ED60, sensor module ED76, communication module ED90, etc.) of the elements in the electronic apparatus ED01. The auxiliary processor ED23 (image signal processor, communication processor, etc.) may be implemented as a part of another element (camera module ED80, communication module ED90, etc.) that is functionally related thereto.

The memory ED30 may store various data required by the elements (processor ED20, sensor module ED76, etc.) of the electronic apparatus ED01. The data may include, for example, input data and/or output data about software (program ED40, etc.) and commands related thereto. The memory ED30 may include the volatile memory ED32 and/or the non-volatile memory ED34.

The program ED40 may be stored as software in the memory ED30, and may include an operation system ED42, middleware ED44, and/or an application ED46.

The input device ED50 may receive commands and/or data to be used in the elements (processor ED20, etc.) of the electronic apparatus ED01, from outside (user, etc.) of the electronic apparatus ED01. The input device ED50 may include a microphone, a mouse, a keyboard, and/or a digital pen (stylus pen).

The sound output device ED55 may output a sound signal to outside of the electronic apparatus ED01. The sound output device ED55 may include a speaker and/or a receiver. The speaker may be used for a general purpose such as multimedia reproduction or record play, and the receiver may be used to receive a call. The receiver may be coupled as a part of the speaker or may be implemented as an independent device.

The display device ED60 may provide visual information to outside of the electronic apparatus ED01. The display device ED60 may include a display, a hologram device, or a projector, and a control circuit for controlling the corresponding device. The display device ED60 may include a touch circuitry set to sense a touch, and/or a sensor circuit (pressure sensor, etc.) that is set to measure a strength of a force generated by the touch.

The audio module ED70 may convert sound into an electrical signal or vice versa. The audio module ED 70 may acquire sound through the input device ED50, or may output sound via the sound output device ED55 and/or a speaker and/or a headphone of another electronic apparatus (electronic apparatus ED02, etc.) connected directly or wirelessly to the electronic apparatus ED01.

The sensor module ED76 may sense an operating state (power, temperature, etc.) of the electronic apparatus ED01, or an outer environmental state (user state, etc.), and may generate an electrical signal and/or data value corresponding to the sensed state. The sensor module ED76 may include a gesture sensor, a gyro-sensor, a pressure sensor, a magnetic sensor, an acceleration sensor, a grip sensor, a proximity sensor, a color sensor, an infrared (IR) ray sensor, a vivo sensor, a temperature sensor, a humidity sensor, and/or an illuminance sensor.

The interface ED77 may support one or more designated protocols that may be used in order for the electronic apparatus ED01 to be directly or wirelessly connected to another electronic apparatus (electronic apparatus ED02, etc.). The interface ED77 may include a high-definition multimedia interface (HDMI), a universal serial bus (USB) interface, an SD card interface, and/or an audio interface.

The connection terminal ED78 may include a connector by which the electronic apparatus ED01 may be physically connected to another electronic apparatus (electronic apparatus ED02, etc.). The connection terminal ED78 may include an HDMI connector, a USB connector, an SD card connector, and/or an audio connector (headphone connector, etc.).

The haptic module ED79 may convert the electrical signal into a mechanical stimulation (vibration, motion, etc.) or an electric stimulation that the user may sense through a tactile or motion sensation. The haptic module ED79 may include a motor, a piezoelectric device, and/or an electric stimulus device.

The camera module ED80 may capture a still image and a video. The camera module ED80 may include a lens assembly including one or more lenses, the image sensor 1000 of FIG. 1, image signal processors, and/or flashes. The lens assembly included in the camera module ED80 may collect light emitted from an object that is an object to be captured.

The power management module ED88 may manage the power supplied to the electronic apparatus ED01. The power management module ED88 may be implemented as a part of a power management integrated circuit (PMIC).

The battery ED89 may supply electric power to components of the electronic apparatus ED01. The battery ED89 may include a primary battery that is not rechargeable, a secondary battery that is rechargeable, and/or a fuel cell.

The communication module ED90 may support the establishment of a direct (wired) communication channel and/or a wireless communication channel between the electronic apparatus ED01 and another electronic apparatus (electronic apparatus ED02, electronic apparatus ED04, server ED08, etc.), and execution of communication through the established communication channel. The communication module ED90 may be operated independently from the processor ED20 (application processor, etc.), and may include one or more communication processors that support the direct communication and/or the wireless communication. The communication module ED90 may include a wireless communication module ED92 (cellular communication module, a short-range wireless communication module, a global navigation satellite system (GNSS) communication module) and/or a wired communication module ED94 (local area network (LAN) communication module, a power line communication module, etc.). From among the communication modules, a corresponding communication module may communicate with another electronic apparatus via a first network ED98 (short-range communication network such as Bluetooth, WiFi direct, or infrared data association (IrDA)) or a second network ED99 (long-range communication network such as a cellular network, Internet, or computer network (LAN, WAN, etc.)). Such above various kinds of communication modules may be integrated as one element (single chip, etc.) or may be implemented as a plurality of elements (a plurality of chips) separately from one another. The wireless communication module ED92 may identify and authenticate the electronic apparatus ED01 in a communication network such as the first network ED98 and/or the second network ED99 by using subscriber information (international mobile subscriber identifier (IMSI), etc.) stored in the subscriber identification module ED96.

The antenna module ED97 may transmit or receive the signal and/or power to/from outside (another electronic apparatus, etc.). An antenna may include a radiator formed as a conductive pattern formed on a substrate (PCB, etc.). The antenna module ED97 may include one or more antennas. When the antenna module ED97 includes a plurality of antennas, from among the plurality of antennas, an antenna that is suitable for the communication type used in the communication network such as the first network ED98 and/or the second network ED99 may be selected by the communication module ED90. The signal and/or the power may be transmitted between the communication module ED90 and another electronic apparatus via the selected antenna. Another component (RFIC, etc.) other than the antenna may be included as a portion of the antenna module ED97.

Some of the elements may be connected to one another via the communication method among the peripheral devices (bus, general purpose input and output (GPIO), serial peripheral interface (SPI), mobile industry processor interface (MIPI), etc.) and may exchange signals (commands, data, etc.).

The command or data may be transmitted or received between the electronic apparatus ED01 and the external electronic apparatus ED04 via the server ED08 connected to the second network ED99. Other electronic apparatuses ED02 and ED04 may be the devices that are the same as or different kinds from the electronic apparatus ED01. All or some of the operations executed in the electronic apparatus ED01 may be executed in one or more devices among the other electronic apparatuses ED02, ED04, and ED08. For example, when the electronic apparatus ED01 has to perform a certain function or service, the electronic apparatus ED01 may request one or more other electronic apparatuses to perform some or entire function or service, instead of executing the function or service by itself. One or more electronic apparatuses receiving the request execute an additional function or service related to the request and may transfer a result of the execution to the electronic apparatus ED01. To do this, for example, a cloud computing, a distributed computing, or a client-server computing technique may be used.

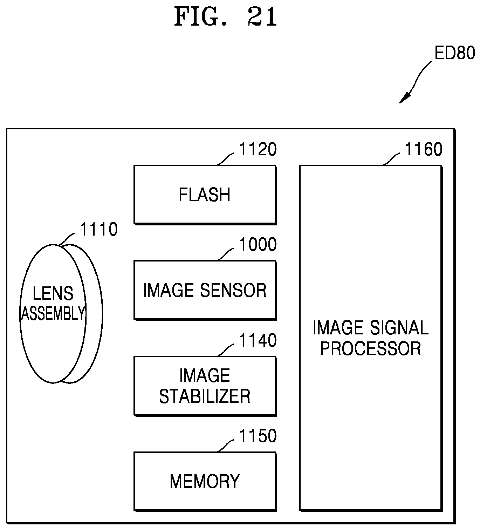

FIG. 21 is a block diagram showing an example of the camera module ED80 included in the electronic apparatus ED01 of FIG. 20. Referring to FIG. 21, the camera module ED80 may include a lens assembly 1110, a flash 1120, an image sensor 1000, an image stabilizer 1140, a memory 1150 (buffer memory, etc.), and/or an image signal processor 1160. The lens assembly 1110 may collect light emitted from an object that is to be captured. The camera module ED80 may include a plurality of lens assemblies 1110, and in this case, the camera module ED80 may include a dual camera module, a 360-degree camera, or a spherical camera. Some of the plurality of lens assemblies 1110 may have the same lens properties (viewing angle, focal distance, auto-focus, F number, optical zoom, etc.) or different lens properties. The lens assembly 1110 may include a wide-angle lens or a telephoto lens.

The flash 1120 may emit light that is used to strengthen the light emitted or reflected from the object. The flash 1120 may emit visible light or infrared-ray light. The flash 1120 may include one or more light-emitting diodes (red-green-blue (RGB) LED, white LED, infrared LED, ultraviolet LED, etc.), and/or a Xenon lamp. The image sensor 1000 may be the image sensor described above with reference to FIG. 1, and converts the light emitted or reflected from the object and transferred through the lens assembly 1110 into an electrical signal to obtain an image corresponding to the object.

The image stabilizer 1140, in response to a motion of the camera module ED80 or the electronic apparatus ED01 including the camera module ED80, moves one or more lenses included in the lens assembly 1110 or the image sensor 1000 in a certain direction or controls the operating characteristics of the image sensor 1000 (adjusting of a read-out timing, etc.) in order to compensate for a negative influence of the motion. The image stabilizer 1140 may sense the movement of the camera module ED80 or the electronic apparatus ED01 by using a gyro sensor (not shown) or an acceleration sensor (not shown) disposed in or out of the camera module ED80. The image stabilizer 1140 may be implemented as an optical type.

The memory 1150 may store some or entire data of the image obtained through the image sensor 1000 for next image processing operation. For example, when a plurality of images are obtained at a high speed, obtained original data (Bayer-patterned data, high-resolution data, etc.) is stored in the memory 1150, and a low-resolution image is only displayed. Then, original data of a selected image (user selection, etc.) may be transferred to the image signal processor 1160. The memory 1150 may be integrated with the memory ED30 of the electronic apparatus ED01, or may include an additional memory that is operated independently.

The image signal processor 1160 may perform image treatment on the image obtained through the image sensor 1000 or the image data stored in the memory 1150. The image treatments may include a depth map generation, a three-dimensional modeling, a panorama generation, extraction of features, an image combination, and/or an image compensation (noise reduction, resolution adjustment, brightness adjustment, blurring, sharpening, softening, etc.). The image signal processor 1160 may perform controlling (exposure time control, read-out timing control, etc.) of the elements (image sensor 1000, etc.) included in the camera module ED80. The image processed by the image signal processor 1160 may be stored again in the memory 1150 for additional process, or may be provided to an external element of the camera module ED80 (e.g., the memory ED30, the display device ED60, the electronic apparatus ED02, the electronic apparatus ED04, the server ED08, etc.). The image signal processor 1160 may be integrated with the processor ED20, or may be configured as an additional processor that is independently operated from the processor ED20. When the image signal processor 1160 is configured as an additional processor separately from the processor ED20, the image processed by the image signal processor 1160 undergoes through an additional image treatment by the processor ED20 and then may be displayed on the display device ED60.

Also, the image signal processor 1160 may receive two output signals independently from the adjacent photosensitive cells in each pixel or sub-pixel of the image sensor 1000, and may generate an auto-focusing signal from a difference between the two output signals. The image signal processor 1160 may control the lens assembly 1110 so that the focus of the lens assembly 1110 may be accurately formed on the surface of the image sensor 1000 based on the auto-focusing signal.

The electronic apparatus ED01 may further include one or a plurality of camera modules having different properties or functions. The camera module may include elements similar to those of the camera module ED80 of FIG. 21, and the image sensor included in the camera module may be implemented as a CCD sensor and/or a CMOS sensor and may include one or a plurality of sensors selected from the image sensors having different properties, such as an RGB sensor, a black and white (BW) sensor, an IR sensor, or a UV sensor. In this case, one of the plurality of camera modules ED80 may include a wide-angle camera and another camera module ED80 may include a telephoto camera. Similarly, one of the plurality of camera modules ED80 may include a front camera and another camera module ED80 may include a rear camera.

While the image sensor including the nano-photonic lens array and the electronic apparatus including the image sensor have been particularly shown and described with reference to exemplary embodiments thereof, it will be understood by those of ordinary skill in the art that various changes in form and details may be made therein without departing from the scope as defined by the following claims. The preferred embodiments should be considered in descriptive sense only and not for purposes of limitation. Therefore, the scope of the disclosure is defined not by the detailed description of the disclosure but by the appended claims, and all differences within the scope will be construed as being included in the present disclosure.

According to the embodiments, the nano-photonic lens array performing both the color-separation and light condensing functions is used, and thus, the light utilization efficiency may be improved. As the light utilization efficiency is improved, a size of one pixel or size of independent photosensitive cells in the pixel of the image sensor may be reduced. Therefore, the ultra-fine pixel image sensor having high resolution may be provided.

Also, according to the embodiments, the nano-photonic lens array may be applied to the image sensor having new pixel arrangement that does not need the demosaic process when using the binning mode. Therefore, the image sensor including the nano-photonic lens array may exhibit an increase in the sensitivity, improvement in a resolution, and improvement in the power consumption under the low-illuminance, while having ultra-fine pixels.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An image sensor (1000) comprising:
a sensor substrate (110) comprising a plurality of pixels including a first pixel type (111), a second pixel type (112), a third pixel type (113), and a fourth pixel type (114), wherein the plurality of pixels are two-dimensionally disposed in a first direction and a second direction such that the plurality of pixels are distributed about each pixel of a second and fourth pixel type with reflectional asymmetry about an axis in each of the first direction (x), the second direction (y), and a first diagonal direction (D1), and are distributed with reflectional symmetry about an axis in a second diagonal direction (D2) that crosses the first diagonal direction; and
a nano-photonic lens array (150) comprising a plurality of pixel corresponding regions including a first pixel corresponding region type (151) corresponding to the first pixel type, a second pixel corresponding region type (152) corresponding to the second pixel type, a third pixel corresponding region type (153) corresponding to the third pixel type, and a fourth pixel corresponding region type (154) corresponding to the fourth pixel type,
wherein each of the plurality of pixel corresponding regions includes a plurality of nano-structures (NP) such that the nano-photonic lens array is configured to condense light of a first wavelength onto pixels of the first pixel type, condense light of a second wavelength onto pixels of the second pixel type and the fourth pixel type, and condense light of a third wavelength onto pixels of the third pixel type, and
**characterized in that** in each pixel corresponding region of the second pixel corresponding region type and the fourth pixel corresponding region type, cross-sectional area sizes of the plurality of nano-structures are distributed with reflectional asymmetry about a central axis of the pixel corresponding region in each of the first direction, the second direction, and the first diagonal direction, and are distributed with reflectional symmetry about a central axis of the pixel corresponding region in the second diagonal direction that crosses the first diagonal direction.

2. The image sensor of claim 1, wherein:
the plurality of pixels are arranged such that in a first row of the sensor substrate a pixel of the first pixel type, a pixel of the second pixel type, a pixel of the third pixel type, and a pixel of the fourth pixel are disposed in sequence in the first direction; and
in a following row of the sensor substrate in the second direction, a pixel of the first pixel type, a pixel of the second pixel type, a pixel of the third pixel type, and a pixel of the fourth pixel type are disposed in sequence shifted by one pixel unit in the first direction compared to the first row of the sensor substrate so that the pixels of the first pixel type, the pixels of the second pixel type, the pixels of the third pixel type, and the pixels of the fourth pixel type are each disposed in a straight line in the first diagonal direction.

3. The image sensor of claim 1, wherein:
The plurality of pixel corresponding regions are arranged such that in a first row of the nano-photonic lens array, a pixel corresponding region of the first pixel corresponding region type, a pixel corresponding region of the second pixel corresponding region type, a pixel corresponding region of the third pixel corresponding region type, and a pixel corresponding region of the fourth pixel corresponding region type are disposed in sequence in the first direction, and
in a following row of the nano-photonic lens array in the second direction, a pixel corresponding region of the first pixel corresponding region type, a pixel corresponding region of the second pixel corresponding region type, a pixel corresponding region of the third pixel corresponding region type, and a pixel corresponding region of the fourth pixel corresponding region type are disposed in sequence in the first direction and are shifted one-by-one in the first direction compared to the first row of the nano-photonic lens array so that the pixel corresponding regions of the first pixel corresponding region type, the pixel corresponding regions of the second pixel corresponding region type, the pixel corresponding regions of the third pixel corresponding region type, and the pixel corresponding regions of the fourth pixel corresponding region type are each disposed in a straight line in the first diagonal direction.

4. The image sensor of any preceding claim, wherein:
in each of the first pixel corresponding region type, the second pixel corresponding region type, the third pixel corresponding region type, and the fourth pixel corresponding region type, the plurality of nano-structures are two-dimensionally disposed; and
in the first pixel corresponding region type, the second pixel corresponding region type, the third pixel corresponding region type, and the fourth pixel corresponding region type, locations, materials, and heights of the plurality of nano-structures are respectively same as one another.

5. The image sensor of any preceding claim, wherein, in the second pixel corresponding region type, at least one pair from among pairs of two nano-structures corresponding to each other in the first direction has different cross-sectional area sizes from each other, at least one pair from among pairs of two nano-structures corresponding to each other in the second direction has different cross-sectional area sizes from each other, at least one pair from among pairs of two nano-structures corresponding to each other in the second diagonal direction has different cross-sectional area sizes from each other, and pairs of two nano-structures corresponding to each other in the first diagonal direction have same cross-sectional area sizes.

6. The image sensor of any preceding claim, wherein, in the fourth pixel corresponding region type, at least one pair from among pairs of two nano-structures corresponding to each other in the first direction has different cross-sectional area sizes from each other, at least one pair from among pairs of two nano-structures corresponding to each other in the second direction has different cross-sectional area sizes from each other, at least one pair from among pairs of two nano-structures corresponding to each other in the first diagonal direction has different cross-sectional area sizes from each other, and pairs of two nano-structures corresponding to each other in the second diagonal direction have same cross-sectional area sizes.

7. The image sensor of any preceding claim, wherein a distribution of cross-sectional area sizes of the plurality of nano-structures in the second pixel corresponding region type and a distribution of cross-sectional area sizes of the plurality of nano-structures in the fourth pixel corresponding region type are mirror-symmetrical with each other in the first diagonal direction, and optionally wherein the cross-sectional area size of each of the plurality of nano-structures in the second pixel corresponding region type is equal to the cross-sectional area size of the nano-structure symmetrically positioned in the first diagonal direction in the fourth pixel corresponding region type.

8. The image sensor of any preceding claim, wherein, in the first pixel corresponding region and the third pixel corresponding region, the cross-sectional area sizes of the plurality of nano-structures are distributed symmetrically in the first direction, the second direction, the first diagonal direction, and the second diagonal direction, and optionally wherein, in each of the first pixel corresponding region and the third pixel corresponding region, two nano-structures corresponding to each other in the first direction have same cross-sectional area sizes, two nano-structures corresponding to each other in the second direction have same cross-sectional area sizes, two nano-structures corresponding to each other in the first diagonal direction have same cross-sectional area sizes, and two nano-structures corresponding to each other in the second diagonal direction have same cross-sectional area sizes.

9. The image sensor of any of claims 1 to 8, wherein, in the first pixel corresponding region type and the third pixel corresponding region type, the cross-sectional area sizes of the plurality of nano-structures are distributed asymmetrically in the first direction and the second direction, and symmetrically in the first diagonal direction and the second diagonal direction, and optionally wherein, in the first pixel corresponding region type and the third pixel corresponding region type, at least one pair from among pairs of two nano-structures corresponding to each other in the first direction has different cross-sectional area sizes from each other, at least one pair from among pairs of two nano-structures corresponding to each other in the second direction has different cross-sectional area sizes from each other, at least two nano-structures corresponding to each other in the first diagonal direction have same cross-sectional area sizes, and two nano-structures corresponding to each other in the second diagonal direction have same cross-sectional area sizes.

10. The image sensor of any preceding claim, wherein each of the first pixel type, the second pixel type, the third pixel type, and the fourth pixel type includes a plurality of photosensitive cells that are grouped in the first direction and the second direction to be two-dimensionally disposed and independently sense incident light.

11. The image sensor of any preceding claim, further comprising
a color filter layer arranged between the sensor substrate and the nano-photonic microlens array,
wherein the color filter layer includes a first color filter type corresponding to the first pixel type and transmitting the light of the first wavelength, a second color filter type corresponding to the second pixel type and transmitting the light of the second wavelength, a third color filter type corresponding to the third pixel type and transmitting the light of the third wavelength, and a fourth color filter type corresponding to the fourth pixel type and transmitting the light of the second wavelength, and optionally wherein:
the first color filter type, the second color filter type, the third color filter type, and the fourth color filter type are alternately disposed in the first direction; and
the first color filter type, the second color filter type, the third color filter type, and the fourth color filter type are shifted by one pixel unit in the first direction in a following row in the second direction so that each of the first color filter type, the second color filter type, the third color filter type, and the fourth color filter type is disposed in a straight line in the first diagonal direction.

12. An electronic apparatus (ED01) comprising:
a lens assembly (1110) for forming an optical image of a subject;
an image sensor (1000) according to any preceding claim configured to convert the optical image formed by the lens assembly into an electrical signal; and
a processor (1160) configured to process a signal generated by the image sensor.

## Patentansprüche

1. Bildsensor (1000), umfassend:
ein Sensorsubstrat (110), das eine Vielzahl von Pixeln umfasst, die einen ersten Pixeltyp (111), einen zweiten Pixeltyp (112), einen dritten Pixeltyp (113) und einen vierten Pixeltyp (114) beinhalten, wobei die Vielzahl von Pixeln zweidimensional in einer ersten Richtung und einer zweiten Richtung so angeordnet ist, dass die Vielzahl von Pixeln um jedes Pixel eines zweiten und vierten Pixeltyps mit einer Reflexionsasymmetrie um eine Achse in jeder von der ersten Richtung (x), der zweiten Richtung (y) und einer ersten Diagonalrichtung (D1) verteilt ist und mit einer Reflexionssymmetrie um eine Achse in einer zweiten Diagonalrichtung (D2), die die erste Diagonalrichtung kreuzt, verteilt ist; und
eine nanophotonische Linsenanordnung (150), die eine Vielzahl von pixelentsprechenden Bereichen umfasst, die einen ersten pixelentsprechenden Bereichstyp (151), der dem ersten Pixeltyp entspricht, einen zweiten pixelentsprechenden Bereichstyp (152), der dem zweiten Pixeltyp entspricht, einen dritten pixelentsprechenden Bereichstyp (153), der dem dritten Pixeltyp entspricht, und einen vierten pixelentsprechenden Bereichstyp (154), der dem vierten Pixeltyp entspricht, beinhalten,
wobei jeder der Vielzahl von pixelentsprechenden Bereichen ein Vielzahl von Nanostrukturen (NP) beinhaltet, so dass die nanophotonische Linsenanordnung dazu konfiguriert ist, Licht einer ersten Wellenlänge auf Pixel des ersten Pixeltyps zu verdichten, Licht einer zweiten Wellenlänge auf Pixel des zweiten Pixeltyps und des vierten Pixeltyps zu verdichten und Licht einer dritten Wellenlänge auf Pixel des dritten Pixeltyps zu verdichten, und
**dadurch gekennzeichnet, dass** in jedem pixelentsprechenden Bereich des zweiten pixelentsprechenden Bereichstyps und des vierten pixelentsprechenden Bereichstyps Querschnittsflächengrößen der Vielzahl von Nanostrukturen mit einer Reflexionsasymmetrie um eine Mittelachse des pixelentsprechenden Bereichs in jeder von der ersten Richtung, der zweiten Richtung und der ersten Diagonalrichtung verteilt sind und mit einer Reflexionssymmetrie um eine Mittelachse des pixelentsprechenden Bereichs in der zweiten Diagonalrichtung, die die erste Diagonalrichtung kreuzt, verteilt sind.

2. Bildsensor nach Anspruch 1, wobei:
die Vielzahl von Pixeln so eingerichtet ist, dass in einer ersten Reihe des Sensorsubstrats ein Pixel des ersten Pixeltyps, ein Pixel des zweiten Pixeltyps, ein Pixel des dritten Pixeltyps und ein Pixel des vierten Pixeltyps in der ersten Richtung hintereinander angeordnet sind; und
in einer folgenden Reihe des Sensorsubstrats in der zweiten Richtung ein Pixel des ersten Pixeltyps, ein Pixel des zweiten Pixeltyps, ein Pixel des dritten Pixeltyps und ein Pixel des vierten Pixeltyps um eine Pixeleinheit in der ersten Richtung im Vergleich zu der ersten Reihe des Sensorsubstrats hintereinander verschoben angeordnet sind, so dass die Pixel des ersten Pixeltyps, die Pixel des zweiten Pixeltyps, die Pixel des dritten Pixeltyps und die Pixel des vierten Pixeltyps jeweils in einer geraden Linie in der ersten Diagonalrichtung angeordnet sind.

3. Bildsensor nach Anspruch 1, wobei:
die Vielzahl von pixelentsprechenden Bereichen so eingerichtet ist, dass in einer ersten Reihe der nanophotonischen Linsenanordnung ein pixelentsprechender Bereich des ersten pixelentsprechenden Bereichstyps, ein pixelentsprechender Bereich des zweiten pixelentsprechenden Bereichstyps, ein pixelentsprechender Bereich des dritten pixelentsprechenden Bereichstyps und ein pixelentsprechender Bereich des vierten pixelentsprechenden Bereichstyps in der ersten Richtung hintereinander angeordnet sind, und
in einer folgenden Reihe der nanophotonischen Linsenanordnung in der zweiten Richtung ein pixelentsprechender Bereich des ersten pixelentsprechenden Bereichstyps, ein pixelentsprechender Bereich des zweiten pixelentsprechenden Bereichstyps, ein pixelentsprechender Bereich des dritten pixelentsprechenden Bereichstyps und ein pixelentsprechender Bereich des vierten pixelentsprechenden Bereichstyps in der ersten Richtung hintereinander angeordnet sind und im Vergleich zu der ersten Reihe der nanophotonischen Linsenanordnung nacheinander in der ersten Richtung verschoben sind, so dass die pixelentsprechenden Bereiche des ersten pixelentsprechenden Bereichstyps, die pixelentsprechenden Bereiche des zweiten pixelentsprechenden Bereichstyps, die pixelentsprechenden Bereiche des dritten pixelentsprechenden Bereichstyps und die pixelentsprechenden Bereiche des vierten pixelentsprechenden Bereichstyps jeweils in einer geraden Linie in der ersten Diagonalrichtung angeordnet sind.

4. Bildsensor nach einem vorhergehenden Anspruch, wobei:
in jedem von dem ersten pixelentsprechenden Bereichstyp, dem zweiten pixelentsprechenden Bereichstyp, dem dritten pixelentsprechenden Bereichstyp und dem vierten pixelentsprechenden Bereichstyp die Vielzahl von Nanostrukturen zweidimensional angeordnet ist; und
in dem ersten pixelentsprechenden Bereichstyp, dem zweiten pixelentsprechenden Bereichstyp, dem dritten pixelentsprechenden Bereichstyp und dem vierten pixelentsprechenden Bereichstyp Stellen, Materialien und Höhen der Vielzahl von Nanostrukturen jeweils zueinander gleich sind.

5. Bildsensor nach einem vorhergehenden Anspruch, wobei in dem zweiten pixelentsprechenden Bereichstyp mindestens ein Paar unter Paaren von zwei Nanostrukturen, die einander in der ersten Richtung entsprechen, voneinander unterschiedliche Querschnittsflächengrößen aufweist, mindestens ein Paar unter Paaren von zwei Nanostrukturen, die einander in der zweiten Richtung entsprechen, voneinander unterschiedliche Querschnittsflächengrößen aufweist, mindestens ein Paar von Paaren unter zwei Nanostrukturen, die einander in der zweiten Diagonalrichtung entsprechen, voneinander unterschiedliche Querschnittsflächengrößen aufweist, und Paare von zwei Nanostrukturen, die einander in der ersten Diagonalrichtung entsprechen, dieselben Querschnittsflächengrößen aufweisen.

6. Bildsensor nach einem vorhergehenden Anspruch, wobei in dem vierten pixelentsprechenden Bereichstyp mindestens ein Paar unter Paaren von zwei Nanostrukturen, die einander in der ersten Richtung entsprechen, voneinander unterschiedliche Querschnittsflächengrößen aufweist, mindestens ein Paar unter Paaren von zwei Nanostrukturen, die einander in der zweiten Richtung entsprechen, voneinander unterschiedliche Querschnittsflächengrößen aufweist, mindestens ein Paar unter Paaren von zwei Nanostrukturen, die einander in der ersten Diagonalrichtung entsprechen, voneinander unterschiedliche Querschnittsflächengrößen aufweist, und Paare von zwei Nanostrukturen, die einander in der zweiten Diagonalrichtung entsprechen, dieselben Querschnittsflächengrößen aufweisen.

7. Bildsensor nach einem vorhergehenden Anspruch, wobei eine Verteilung von Querschnittsflächengrößen der Vielzahl von Nanostrukturen in dem zweiten pixelentsprechenden Bereichstyp und eine Verteilung von Querschnittsflächengrößen der Vielzahl von Nanostrukturen in dem vierten pixelentsprechenden Bereichstyp zueinander in der ersten Diagonalrichtung spiegelsymmetrisch sind, und wobei optional die Querschnittsflächengröße jeder der Vielzahl von Nanostrukturen in dem zweiten pixelentsprechenden Bereichstyp gleich der Querschnittsflächengröße der Nanostruktur ist, die symmetrisch in der ersten Diagonalrichtung in dem vierten pixelentsprechenden Bereichstyp positioniert ist.

8. Bildsensor nach einem vorhergehenden Anspruch, wobei in dem ersten pixelentsprechenden Bereich und dem dritten pixelentsprechenden Bereich die Querschnittsflächengrößen der Vielzahl von Nanostrukturen symmetrisch in der ersten Richtung, der zweiten Richtung, der ersten Diagonalrichtung und der zweiten Diagonalrichtung verteilt sind, und wobei optional in jedem von dem ersten pixelentsprechenden Bereich und dem dritten pixelentsprechenden Bereich zwei Nanostrukturen, die einander in der ersten Richtung entsprechen, dieselben Querschnittsflächengrößen aufweisen, zwei Nanostrukturen, die einander in der zweiten Richtung entsprechen, dieselben Querschnittsflächengrößen aufweisen, zwei Nanostrukturen, die einander in der ersten Diagonalrichtung entsprechen, dieselben Querschnittsflächengrößen aufweisen und zwei Nanostrukturen, die einander in der zweiten Diagonalrichtung entsprechen, dieselben Querschnittsflächengrößen aufweisen.

9. Bildsensor nach einem der Ansprüche 1 bis 8, wobei in dem ersten pixelentsprechenden Bereichstyp und dem dritten pixelentsprechenden Bereichstyp die Querschnittsflächengrößen der Vielzahl von Nanostrukturen asymmetrisch in der ersten Richtung und der zweiten Richtung und symmetrisch in der ersten Diagonalrichtung und der zweiten Diagonalrichtung verteilt sind, und wobei optional in dem ersten pixelentsprechenden Bereichstyp und dem dritten pixelentsprechenden Bereichstyp mindestens ein Paar unter Paaren von zwei Nanostrukturen, die einander in der ersten Richtung entsprechen, voneinander unterschiedliche Querschnittsflächengrößen aufweist, mindestens ein Paar unter Paaren von zwei Nanostrukturen, die einander in der zweiten Richtung entsprechen, voneinander unterschiedliche Querschnittsflächengrößen aufweist, mindestens zwei Nanostrukturen, die einander in der ersten Diagonalrichtung entsprechen, dieselben Querschnittsflächengrößen aufweisen und zwei Nanostrukturen, die einander in der zweiten Diagonalrichtung entsprechen, dieselben Querschnittsflächengrößen aufweisen.

10. Bildsensor nach einem vorhergehenden Anspruch, wobei jeder von dem ersten Pixeltyp, dem zweiten Pixeltyp, dem dritten Pixeltyp und dem vierten Pixeltyp eine Vielzahl von lichtempfindlichen Zellen beinhaltet, die in der ersten Richtung und der zweiten Richtung gruppiert sind, um zweidimensional angeordnet zu sein und einfallendes Licht unabhängig zu erfassen.

11. Bildsensor nach einem vorhergehenden Anspruch, ferner umfassend
eine Farbfilterschicht, die zwischen dem Sensorsubstrat und der nanophotonischen Mikrolinsenanordnung eingerichtet ist,
wobei die Farbfilterschicht einen ersten Farbfiltertyp, der dem ersten Pixeltyp entspricht und das Licht der ersten Wellenlänge überträgt, einen zweiten Farbfiltertyp, der dem zweiten Pixeltyp entspricht und das Licht der zweiten Wellenlänge überträgt, einen dritten Farbfiltertyp, der dem dritten Pixeltyp entspricht und das Licht der dritten Wellenlänge überträgt, und einen vierten Farbfiltertyp, der dem vierten Pixeltyp entspricht und das Licht der zweiten Wellenlänge überträgt, beinhaltet, und wobei optional:
der erste Farbfiltertyp, der zweite Farbfiltertyp, der dritte Farbfiltertyp und der vierte Farbfiltertyp abwechselnd in der ersten Richtung angeordnet sind; und
der erste Farbfiltertyp, der zweite Farbfiltertyp, der dritte Farbfiltertyp und der vierte Farbfiltertyp in einer folgenden Reihe in der zweiten Richtung um eine Pixeleinheit in der ersten Richtung verschoben sind, so dass jeder von dem ersten Farbfiltertyp, dem zweiten Farbfiltertyp, dem dritten Farbfiltertyp und dem vierten Farbfiltertyp in einer geraden Linie in der ersten Diagonalrichtung angeordnet ist.

12. Elektronische Vorrichtung (ED01), umfassend:
eine Linsenanordnung (1110) zum Bilden eines optischen Bildes eines Motivs;
einen Bildsensor (1000) nach einem vorhergehenden Anspruch, der dazu konfiguriert ist, das optische Bild, das durch die Linsenanordnung gebildet wird, in ein elektrisches Signal umzuwandeln; und
einen Prozessor (1160), der dazu konfiguriert ist, ein durch den Bildsensor generiertes Signal zu verarbeiten.

## Revendications

1. Capteur d'image (1000) comprenant :
un substrat de capteur (110) comprenant une pluralité de pixels comprenant un premier type de pixel (111), un deuxième type de pixel (112), un troisième type de pixel (113) et un quatrième type de pixel (114), ladite pluralité de pixels étant disposés de manière bidimensionnelle dans une première direction et une seconde direction de sorte que la pluralité de pixels soient distribués autour de chaque pixel d'un second et d'un quatrième type de pixel avec une asymétrie de réflexion autour d'un axe dans chacune de la première direction (x), de la seconde direction (y) et d'une première direction diagonale (D1), et soient distribués avec une symétrie de réflexion autour d'un axe dans une seconde direction diagonale (D2) qui croise la première direction diagonale ; et
un réseau de lentilles nanophotoniques (150) comprenant une pluralité de zones correspondant à un pixel comprenant un premier type de zone correspondant à un pixel (151) correspondant au premier type de pixel, un deuxième type de zone correspondant à un pixel (152) correspondant au deuxième type de pixel, un troisième type de zone correspondant à un pixel (153) correspondant au troisième type de pixel, et un quatrième type de zone correspondant à un pixel (154) correspondant au quatrième type de pixel,
chacune de la pluralité de zones correspondant à un pixel comprenant une pluralité de nanostructures (NP) de sorte que le réseau de lentilles nanophotoniques soit configuré pour concentrer de la lumière d'une première longueur d'onde sur des pixels du premier type de pixel, concentrer de la lumière d'une deuxième longueur d'onde sur des pixels du deuxième type de pixel et du quatrième type de pixel, et concentrer de la lumière d'une troisième longueur d'onde sur des pixels du troisième type de pixel, et
**caractérisé en ce que** dans chaque zone correspondant à un pixel du deuxième type de zone correspondant à un pixel et du quatrième type de zone correspondant à un pixel, les tailles de section transversale de la pluralité de nanostructures sont distribuées avec une asymétrie de réflexion autour d'un axe central de la zone correspondant à un pixel dans chacune de la première direction, de la seconde direction et de la première direction diagonale, et sont distribuées avec une symétrie de réflexion autour d'un axe central de la zone correspondant à un pixel dans la seconde direction diagonale qui croise la première direction diagonale.

2. Capteur d'image de la revendication 1 :
ladite pluralité de pixels étant agencés de sorte que dans une première rangée du substrat de capteur, un pixel du premier type de pixel, un pixel du deuxième type de pixel, un pixel du troisième type de pixel et un pixel du quatrième pixel soient disposés en séquence dans la première direction ; et
dans une rangée suivante du substrat de capteur dans la seconde direction, un pixel du premier type de pixel, un pixel du deuxième type de pixel, un pixel du troisième type de pixel et un pixel du quatrième type de pixel soient disposés en séquence décalés d'une unité de pixel dans la première direction par rapport à la première rangée du substrat de capteur afin que les pixels du premier type de pixel, les pixels du deuxième type de pixel, les pixels du troisième type de pixel et les pixels du quatrième type de pixel soient chacun disposés en ligne droite dans la première direction diagonale.

3. Capteur d'image de la revendication 1 :
ladite pluralité de zones correspondant à un pixel étant agencées de sorte que dans une première rangée du réseau de lentilles nanophotoniques, une zone correspondant à un pixel du premier type de zone correspondant à un pixel, une zone correspondant à un pixel du deuxième type de zone correspondant à un pixel, une zone correspondant à un pixel du troisième type de zone correspondant à un pixel et une zone correspondant à un pixel du quatrième type de zone correspondant à un pixel soient disposées en séquence dans la première direction, et
dans une rangée suivante du réseau de lentilles nanophotoniques dans la seconde direction, une zone correspondant à un pixel du premier type de zone correspondant à un pixel, une zone correspondant à un pixel du deuxième type de zone correspondant à un pixel, une zone correspondant à un pixel du troisième type de zone correspondant à un pixel et une zone correspondant à un pixel du quatrième type de zone correspondant à un pixel soient disposées en séquence dans la première direction et soient décalées une à une dans la première direction par rapport à la première rangée du réseau de lentilles nanophotoniques afin que les zones correspondant à un pixel du premier type de zone correspondant à un pixel, les zones correspondant à un pixel du deuxième type de zone correspondant à un pixel, les zones correspondant à un pixel du troisième type de zone correspondant à un pixel et les zones correspondant à un pixel du quatrième type de zone correspondant à un pixel soient chacune disposées en ligne droite dans la première direction diagonale.

4. Capteur d'image d'une quelconque revendication précédente :
dans chacun du premier type de zone correspondant à un pixel, du deuxième type de zone correspondant à un pixel, du troisième type de zone correspondant à un pixel et du quatrième type de zone correspondant à un pixel, ladite pluralité de nanostructures étant disposées de manière bidimensionnelle ; et
dans le premier type de zone correspondant à un pixel, le deuxième type de zone correspondant à un pixel, le troisième type de zone correspondant à un pixel et le quatrième type de zone correspondant à un pixel, lesdits emplacements, lesdits matériaux et lesdites hauteurs de la pluralité de nanostructures étant respectivement identiques les uns aux autres.

5. Capteur d'image d'une quelconque revendication précédente, dans le second type de zone correspondant à un pixel, au moins une paire parmi des paires de deux nanostructures correspondant l'une à l'autre dans la première direction possédant des tailles de section transversale différentes l'une de l'autre, au moins une paire parmi des paires de deux nanostructures correspondant l'une à l'autre dans la seconde direction possédant des tailles de section transversale différentes l'une de l'autre, au moins une paire parmi des paires de deux nanostructures correspondant l'une à l'autre dans la seconde direction diagonale possédant des tailles de section transversale différentes l'une de l'autre, et des paires de deux nanostructures correspondant l'une à l'autre dans la première direction diagonale possédant des tailles de section transversale identiques.

6. Capteur d'image d'une quelconque revendication précédente, dans le quatrième type de zone correspondant à un pixel, au moins une paire parmi des paires de deux nanostructures correspondant l'une à l'autre dans la première direction possédant des tailles de section transversale différentes l'une de l'autre, au moins une paire parmi des paires de deux nanostructures correspondant l'une à l'autre dans la seconde direction possédant des tailles de section transversale différentes l'une de l'autre, au moins une paire parmi des paires de deux nanostructures correspondant l'une à l'autre dans la première direction diagonale possédant des tailles de section transversale différentes l'une de l'autre, et des paires de deux nanostructures correspondant l'une à l'autre dans la seconde direction diagonale possédant des tailles de section transversale identiques.

7. Capteur d'image d'une quelconque revendication précédente, une distribution des tailles de section transversale de la pluralité de nanostructures dans le deuxième type de zone correspondant à un pixel et une distribution des tailles de section transversale de la pluralité de nanostructures dans le quatrième type de zone correspondant à un pixel étant symétriques l'un de l'autre par réflexion dans la première direction diagonale, et éventuellement ladite taille de section transversale de chacune de la pluralité de nanostructures dans le deuxième type de zone correspondant à un pixel étant égale à la taille de section transversale de la nanostructure positionnée symétriquement dans la première direction diagonale dans le quatrième type de zone correspondant à un pixel.

8. Capteur d'image d'une quelconque revendication précédente, dans la première zone correspondant à un pixel et la troisième zone correspondant à un pixel, lesdites tailles de section transversale de la pluralité de nanostructures étant distribuées symétriquement dans la première direction, la seconde direction, la première direction diagonale et la seconde direction diagonale, et éventuellement dans chacune de la première zone correspondant à un pixel et de la troisième zone correspondant à un pixel, deux nanostructures correspondant l'une à l'autre dans la première direction possédant des tailles de section transversale identiques, deux nanostructures correspondant l'une à l'autre dans la seconde direction possédant des tailles de section transversale identiques, deux nanostructures correspondant l'une à l'autre dans la première direction diagonale possédant des tailles de section transversale identiques, et deux nanostructures correspondant l'une à l'autre dans la seconde direction diagonale possédant des tailles de section transversale identiques.

9. Capteur d'image d'une quelconque des revendications 1 à 8, dans le premier type de zone correspondant à un pixel et le troisième type de zone correspondant à un pixel, les tailles de section transversale de la pluralité de nanostructures étant distribuées asymétriquement dans la première direction et la seconde direction, et symétriquement dans la première direction diagonale et la seconde direction diagonale, et éventuellement, dans le premier type de zone correspondant à un pixel et le troisième type de zone correspondant à un pixel, au moins une paire parmi des paires de deux nanostructures correspondant l'une à l'autre dans la première direction possédant des tailles de section transversale différentes l'une de l'autre, au moins une paire parmi des paires de deux nanostructures correspondant l'une à l'autre dans la seconde direction possédant des tailles de section transversale différentes l'une de l'autre, au moins deux nanostructures correspondant l'une à l'autre dans la première direction diagonale possédant des tailles de section transversale identiques, et deux nanostructures correspondant l'une à l'autre dans la seconde direction diagonale possédant des tailles de section transversale identiques.

10. Capteur d'image d'une quelconque revendication précédente, chacun du premier type de pixel, du deuxième type de pixel, du troisième type de pixel et du quatrième type de pixel comprenant une pluralité de cellules photosensibles qui sont regroupées dans la première direction et la seconde direction pour être disposées de manière bidimensionnelle et détecter indépendamment la lumière incidente.

11. Capteur d'image d'une quelconque revendication précédente, comprenant en outre une couche de filtre coloré agencée entre le substrat de capteur et le réseau de microlentilles nanophotoniques,
ladite couche de filtre coloré comprenant un premier type de filtre coloré correspondant au premier type de pixel et transmettant la lumière de la première longueur d'onde, un deuxième type de filtre coloré correspondant au deuxième type de pixel et transmettant la lumière de la deuxième longueur d'onde, un troisième type de filtre coloré correspondant au troisième type de pixel et transmettant la lumière de la troisième longueur d'onde, et un quatrième type de filtre coloré correspondant au quatrième type de pixel et transmettant la lumière de la deuxième longueur d'onde, et éventuellement :
ledit premier type de filtre coloré, ledit deuxième type de filtre coloré, ledit troisième type de filtre coloré et ledit quatrième type de filtre coloré étant alternativement disposés dans la première direction ; et
ledit premier type de filtre coloré, ledit deuxième type de filtre coloré, ledit troisième type de filtre coloré et ledit quatrième type de filtre coloré étant décalés d'une unité de pixel dans la première direction dans une rangée suivante dans la seconde direction afin que chacun du premier type de filtre coloré, du deuxième type de filtre coloré, du troisième type de filtre coloré et du quatrième type de filtre coloré soit disposé en ligne droite dans la première direction diagonale.

12. Appareil électronique (ED01), comprenant :
un ensemble lentille (1110) destiné à former une image optique d'un sujet ;
un capteur d'image (1000) selon une quelconque revendication précédente configuré pour convertir l'image optique formée par l'ensemble lentille en un signal électrique ; et
un processeur (1160) configuré pour traiter un signal généré par le capteur d'image.
